(19) Europäisches Patentamt
European Patent Office
Office européen des brevets

(11) **EP 1 716 800 A2**

(12) **EUROPEAN PATENT APPLICATION**

(43) Date of publication:
**02.11.2006 Bulletin 2006/44**

(51) Int Cl.:
*A47K 10/36* (2006.01)     *H05F 3/02* (2006.01)

(21) Application number: **06118266.3**

(22) Date of filing: **11.02.2002**

(84) Designated Contracting States:
**AT BE CH CY DE DK ES FI FR GB GR IE IT LI LU MC NL PT SE TR**

(30) Priority: **09.02.2001 US 780733**
**27.09.2001 US 966275**
**27.09.2001 US 966124**

(62) Document number(s) of the earlier application(s) in accordance with Art. 76 EPC:
**02250924.4 / 1 231 823**

(71) Applicant: **GEORGIA-PACIFIC CORPORATION Atlanta, GA 30303 (US)**

(72) Inventors:
• **Broehl, Joshua M.**
  **Worthing, WI 43085 (US)**
• **Moody, John R.**
  **Neenah, WI 54956 (US)**

(74) Representative: **Molnia, David**
**df-mp Dörries, Frank-Molnia & Pohlman**
**Triftstrasse 13**
**80538 München (DE)**

Remarks:
This application was filed on 01 - 08 - 2005 as a divisional application to the application mentioned under INID code 62.

(54) **Dispenser with grounding means and method therfor**

(57)     Apparatus for dispensing paper from rolls which feeds continuously, roll to roll, and does not require extra procedure to bring stub roll into position. The apparatus has means for holding and positioning at least first and second rolls of paper with respect to each other; means for dispensing paper from the first roll; means for dispensing paper from the first and second rolls simultaneously when the first roll reduces to a predetermined diameter of paper, means for positioning the depleted first roll for replacement without the necessity of removing the second roll; and, means for dispensing from the second and replacement rolls simultaneously when the second roll reduces to a predetermined diameter of paper.

The apparatus also has a capacity-change-based proximity sensor comprising a circuit according to a balanced bridge principle where detection is based on detecting a phase difference, which depends upon the amount of detected capacitance difference or change. The proximity detector senses when a hand is placed near the dispenser, and thereupon dispenses a set amount of towel. It does not keep dispensing the towel. The hand must be withdrawn and placed in proximity to the sensor again. The proximity sensor incorporates "static" and noise-immunity circuitry. The dispenser incorporates means for dissipating static charges to a local ground.

**EP 1 716 800 A2**

## Description

FIELD OF THE INVENTION

This invention relates to the field of paper roll dispensers. In particular it relates to a carousel dispensing system for paper towels adapted to dispense paper from a plurality of rolls. This invention relates to the field of proximity sensors. In particular it relates to the field of phase-balance proximity sensors.

BACKGROUND

As is readily apparent, a long-standing problem is to keep paper towel available in a dispenser and at the same time use up each roll as completely as possible to avoid paper waste. As part of this system, one ought to keep in mind the person who refills the towel dispenser. An optimal solution would make it as easy as possible and as "fool-proof" as possible to operate the towel refill system and have it operate in such a manner as the least amount of waste of paper towel occurs. This waste may take the form of "stub" rolls of paper towel not being used up.

Transfer devices are used on some roll towel dispensers as a means of reducing waste and decreasing operating costs. These transfer devices work in a variety of ways. The more efficient of these devices automatically begin feeding from a reserve roll once the initial roll is exhausted. These devices eliminate the waste caused by a maintenance person when replacing small rolls with fresh rolls in an effort to prevent the dispenser from running out of paper. These transfer devices, however, tend to be difficult to load and/or to operate. Consequently, these transfer devices are less frequently used, even though they are present.

The current transfer bar mechanisms tend to require the maintenance person to remove any unwanted core tube(s), remove the initial partial roll from the reserve position, and position the initial partial roll into the now vacant stub roll position. This procedure is relatively long and difficult, partly because the stub roll positions in these current paper towel dispensers tend to be cramped and difficult to get to.

In order to keep a roll available in the dispenser, it is necessary to provide for a refill before the roll is used up. This factor generally requires that a "refill" be done before the current paper towel roll is used up. If the person refilling the dispenser comes too late, the paper towel roll will be used up. If the refill occurs too soon, the amount of paper towel in the almost used-up roll, the "stub" roll, will be wasted unless there is a method and a mechanism for using up the stub roll even though the dispenser has been refilled. Another issue exists, as to the ease in which the new refill roll is added to the paper towel dispenser. The goal is to bring "on-stream" the new refill roll as the last of the stub roll towel is being used up. If it is a task easily done by the person replenishing the dispensers, then a higher probability exists that the stub roll paper towel will actually be used up and also that a refill roll be placed into service before the stub roll has entirely been used up. It would be extremely desirable to have a paper towel dispenser which tended to minimize paper wastage by operating in a nearly "fool proof" manner with respect to refilling and using up the stub roll.

As an enhancement and further development of a system for delivering paper towel to the end user in as cost effective manner and in a user-friendly manner as possible, an automatic means for dispensing the paper towel is desirable, making it unnecessary for a user to physically touch a knob or a lever.

It has long been known that the insertion of an object with a dielectric constant into a volume with an electrostatic field will tend to modify the properties which the electrostatic field sees. For example, sometimes it is noticed that placing one hand near some radios will change the tuning of that radio. In these cases, the property of the hand, a dielectric constant dose to that of water, is enough to alter the net capacitance of a tuned circuit within the radio, where that circuit affects the tuning of the RF signal being demodulated by that radio. In 1973 Riechmann (U.S. Patent No. 3,743,865) described a circuit which used two antenna structures to detect an intrusion in the effective space of the antennae. Frequency and amplitude of a relaxation oscillator were affected by affecting the value of its timing capacitor.

The capacity (C) is defined as the charge (Q) stored on separated conductors with a voltage (V) difference between the conductors:

$$C = Q/V.$$

For two infinite conductive planes with a charge per unit area of $\sigma$, a separation of d, with a dielectric constant $\epsilon$ of the material between the infinite conductors, the capacitance of an area A is given by:

$$C = \epsilon \, A\sigma/d$$

Thus, where part of the separating material has a dielectric constant $\epsilon_1$ and part of the material has the dielectric constant $\epsilon_2$, the net capacity is:

$$C = \epsilon_1 A_1 \sigma/d + \epsilon_2 A_2 \sigma/d$$

The human body is about 70% water. The dielectric constant of water is $7.18 \times 10^{-10}$ farads/meter compared to the dielectric constant of air (STP): $8.85 \times 10^{-12}$ farads/meter. The dielectric constant of water is over 80 times the dielectric constant of air. For a hand thrust into one part of space between the capacitor plates, occupying, for example, a hundredth of a detection region between large, but finite parallel conducting plates, a desirable detection ability in terms of the change in capacity is about $10^{-4}$. About $10^{-2}$ is contributed by the difference in the dielectric constants and about $10^{-2}$ is contributed by the "area" difference.

Besides Riechmann (1973), other circuits have been used for, or could be used for proximity sensing.

An important aspect of a proximity detector circuit of this type is that it be inexpensive, reliable, and easy to manufacture. A circuit made of a few parts tends to help with reliability, cost and ease of manufacture. Another desirable characteristic for electronic circuits of this type is that they have a high degree of noise immunity, i.e., that they work well where there may be electromagnetic noise and interference. The circuit will perform better in more locations. It will have acceptable performance in more areas of application.

One form of the invention is a method for grounding a dispenser to a local ground. The method includes the steps of: providing an internal low-impedance path from positions internal to and on the surface of the dispenser where static electrical charges tend to accumulate; and, connecting the low-impedance path to a metal wall-contact spring disposed so as to contact a ground surface when the dispenser is mounted. The static electrical charges are discharged to a local ground through the grounding surface.

Preferably, the method further includes the step of connecting a nib roller shaft of a paper towel dispenser to a grounding wire. More preferably, the method includes the step of utilizing a spring contact to connect said nib roller shaft to said grounding wire.

In another form, the invention is a grounding mechanism for a dispenser. The grounding mechanism includes: a low-impedance grounding wire; a spring contact connected to the grounding wire and disposed to connect to a location of static electricity accumulation in the dispenser; and, a metal wall-contact spring grounding clip connected to the grounding wire and disposed to contact by spring pressure a wall for electrical contact to a local ground.

Preferably, the dispenser is a paper towel dispenser, and the grounding wire is disposed to connect to a nib roller shaft of the dispenser.

The spring contact may be disposed to connect to a nib roller compression spring that is disposed to contact a metal nib roller.

The invention may also be a dispenser with any of the grounding mechanisms mentioned above. The dispenser may include: a first support adapted to hold a first roll of paper; a second support adapted to hold a second roll of paper; a third support rigidly connected to the first and second supports and rotatable about an axis; and, a transfer bar by which paper from the second roll can be dispensed together with paper from the first roll. Preferably, the dispenser further includes a detector adapted to trigger dispensing of paper from the dispenser when a user's hand is positioned within the field of the sensor.

SUMMARY OF THE INVENTION

The invention comprises to a carousel-based dispensing system for paper towels, in particular, which acts to minimize actual wastage of paper towels. The invention comprises means for holding and positioning at least first and second rolls of paper with respect to each other, means for dispensing paper from the first roll, means for dispensing paper from the first and second rolls simultaneously when the first roll reduces to a predetermined diameter of paper, means for positioning the depleted first roll for replacement without the necessity of removing the second roll and means for dispensing from the second and replacement rolls simultaneously when the second roll reduces to a predetermined diameter of paper.

The proximity sensor embodiment comprises a circuit according to a balanced bridge principle where detection is based on detecting a phase difference, which depends upon the amount of detected capacitance difference or change of capacitance in a region of detection.

A second embodiment of this invention comprises a second electronic proximity sensor. The second detector circuit is a miniaturized, micro-powered, capacitance-based proximity sensor designed to detect the approach of a hand to a towel dispenser. It features stable operation and a three-position sensitivity selector.

A third embodiment of this invention comprises a method, apparatus and system for grounding static electrical build-up on paper towel dispensers to a high-impedance local electrical ground. This invention utilizes a high-conductivity pathway to interconnect any internal components subject to static electric build-up. This high-conductivity, low-impedance internal ground leads to an electrical-mechanical contact on the outside of the dispenser. A metal contact between the high-conductivity pathway and, for example, the wall against which the dispenser is mounted provides an electrical-mechanical contact for the dissipation of the static electrical build-up on the dispenser by way of a high-impedance local electrical ground such as the wall.

One aspect of the invention is a method for grounding a dispenser to a local ground, including the steps of: providing an internal low-impedance path for static electrical charges which accumulate during use of the dispenser; and, connecting the low-impedance path to a contactor disposed so as to contact a grounding surface when the dispenser is mounted. The static electrical charges are discharged to a local ground through the grounding surface.

Preferably, the low-impedance path is formed by a grounding wire, and the method further includes the step of connecting a nib roller shaft of the dispenser to the grounding wire. More preferably, the method also includes the step of utilizing a spring contact to connect the nib roller shaft to the grounding wire.

The contactor may be a metal wall-contact spring.

Another aspect of the invention is a grounding mechanism for a dispenser. The grounding mechanism includes: a means for providing an internal low-impedance path for static electrical charges which accumulate during use of the dispenser; and, a means for connecting the low-impedance path to a contactor disposed so as to contact a grounding surface when the dispenser is mounted. Static electrical charges are discharged to a local ground through the grounding surface. The grounding mechanism may include; a low-impedance grounding wire; a spring contact connected to the grounding wire and disposed to connect to a location of static electricity accumulation in the dispenser; and, a metal wall-contact spring grounding clip connected to the grounding wire and disposed to contact by spring pressure a wall for electrical contact to a local ground. Preferably, the grounding wire is disposed to connect to a nib roller shaft of the dispenser. More preferably, the spring contact is disposed to connect to a nib roller compression spring that is disposed to contact a metal nib roller.

Another aspect of the invention is a dispenser that includes the above-mentioned grounding mechanism. The dispenser may include: a first support adapted to hold a first roll of paper; a second support adapted to hold a second roll of paper; a third support rigidly connected to the first and second supports and rotatable about an axis; and, a transfer bar by which paper from the second roll can be dispensed together with paper from the first roll. Such dispenser may further include a detector adapted to trigger dispensing of paper from the dispenser when a user's hand is positioned within the field of a sensor.

BRIEF DESCRIPTION OF THE DRAWINGS

Preferred features of the present invention will now be described, by way of example only, with reference to the accompanying drawings, in which:-

Figure 1 is a side elevation of the dispenser with the cover closed, with no internal mechanisms visible;
Figure 2 is a perspective view of the dispenser with the cover closed, with no internal mechanisms visible;
Figure 3 shows a view of the carousel support, the locking bar and the transfer bar;
Figure 4A is a perspective view of the of the dispenser with the carousel and transfer bar, fully loaded with a main roll and a stub roll;
Figure 4B is a side view of the locking bar showing the placement of the compression springs;
Figure 4C shows the locking mechanism where the locking bar dosest to the rear of the casing is adapted to fit into a mating structure in the rear casing;
Figure 5 is a perspective, exploded view of the carousel assembly;
Figure 6A is a side elevation view of the paper feeding from the stub roll while the tail of the main roll is positioned beneath the transfer bar,
Figure 6B is a side elevation view of the stub roll is completely exhausted, so that the transfer bar tucks the tail of the main roll into the feed mechanism;
Figure 7A is a side elevation view of the carousel ready for loading when the main roll reaches a specific diameter;
Figure 7B is a side elevation view of the locking bar being pulled forwardly to allow the carousel to rotate 180E, placing the main roll in the previous stub roll position;
Figure 7C shows the extension springs which tend to maintain the transfer bar legs in contact with the stub roll;
Figure 7D shows the cleanable floor of the dispenser;
Figure 8A shows a schematic of the proximity circuit;
Figure 8B (prior art) shows the schematic for the National Semiconductor dual comparator LM393;
Figure 9A shows the square wave output at U1A, pin 1;
Figure 9B shows the RC exponential waveforms at pins 5;
Figure 9C shows the RC exponential waveforms at pin 6;
Figure 10 shows a schematic of a second proximity switch;
Figure 10A shows the asymmetric oscillator and the first static protection circuit;
Figure 10B shows the antenna, the antenna reset circuit, a second static protection circuit, the antenna buffer unity follower circuit, and the peak detector circuit; and a peak detector circuit;
Figure 10C shows the low pass filter for rejecting 50/60 Hz, the amplifier circuit, and the test points for adjusting VR1 to 3.0 V with all eternal capacitance-like loads in place;
Figure 10D shows the auto-compensate capacitor, the 50/60 Hz reject capacitor, and the output comparator which will produce an output pulse for signals which have passed all the rejection tests; these tests designed to prevent spurious signals from setting off an output pulse;
Figure 10E shows a sensitivity select switch and circuit;
Figure 11A is a perspective view of a paper towel dispenser with an access hole for the grounding wire, and shows a molded rib which prevents the low-impedance grounding wire from contacting an idler gear;
Figure 11B is a perspective view of a screw boss and molded ribs for attaching the wall contact spring grounding clip to the chassis of the dispenser;
Figure 11C is another perspective view of the screw boss and ribs for attaching the wall contact spring grounding clip to the chassis;

Figure 12A is a perspective view of the gear cover with a molded rib that holds the spring contact in place;

Figure 12B is a perspective view of the grounding wire contacting the spring clip and entering an access hole toward its other end;

Figure 12C is a side elevational view of the towel dispenser showing the grounding wire, the spring contact which connects to the grounding wire and also connects to the wall contact spring grounding clip;

Figure 13 is a perspective view of the path of the grounding wire after it enters the access hole;

Figure 14A is a rear, perspective view of the opening for the wall contact spring grounding clip of the towel dispenser;

Figure 14B is a perspective view of the wall contact spring grounding clip in place in the back of the paper-towel-dispensing unit;

Figure 15 is a perspective view of the static charge flow path including the nib roller to the nib roller shaft, the compression spring, the spring contact, and the grounding wire; and,

Figure 16 is an elevational view showing the compression spring.

## DETAILED DESCRIPTION OF THE PREFERRED EMBODIMENTS

The following description is of the best mode presently contemplated for carrying out the invention. This description is not to be taken in a limiting sense, but is merely made for the purpose of describing the general principles of the invention. The scope of the invention should be determined with reference to the claims.

An embodiment of the invention comprises a carousel-based dispensing system with a transfer bar for paper towels, which acts to minimize actual wastage of paper towels. As an enhancement and further development of a system for delivering paper towel to the end user in a cost effective manner and in as user-friendly manner as possible, an automatic means for dispensing the paper towel is desirable, making it unnecessary for a user to physically touch a knob or a lever. An electronic proximity sensor is included as part of the paper towel dispenser. A person can approach the paper towel dispenser, extend his or her hand, and have the proximity sensor detect the presence of the hand. The embodiment of the invention as shown here, is a system, which advantageously uses a minimal number of parts for both the mechanical structure and for the electronic unit. It has, therefore, an enhanced reliability and maintainability, both of which contribute to cost effectiveness.

An embodiment of the invention comprises a carousel-based dispensing system with a transfer bar for paper towels, which acts to minimize actual wastage of paper towels. The transfer bar coupled with the carousel system is easy to load by a service person; consequently it will tend to be used, allowing stub rolls to be fully utilized. In summary, the carousel assembly-transfer bar comprises two components, a carousel assembly and a transfer bar. The carousel rotates a used-up stub roll to an up position where it can easily be replaced with a full roll. At the same time the former main roll which has been used up such that its diameter is less than some p inches, where p is a rational number, is rotated down into the stub roll position. The tail of the new main roll in the upper position is tucked under the "bar" part of the transfer bar. As the stub roll is used up, the transfer bar moves down under spring loading until the tail of the main roll is engaged between the feed roller and the nlb roller. The carousel assembly is symmetrical about a horizontal axis. A locking bar is pulled out to unlock the carousel assembly and allow it to rotate about its axis, and is then released under its spring loading to again lock the carousel assembly in place.

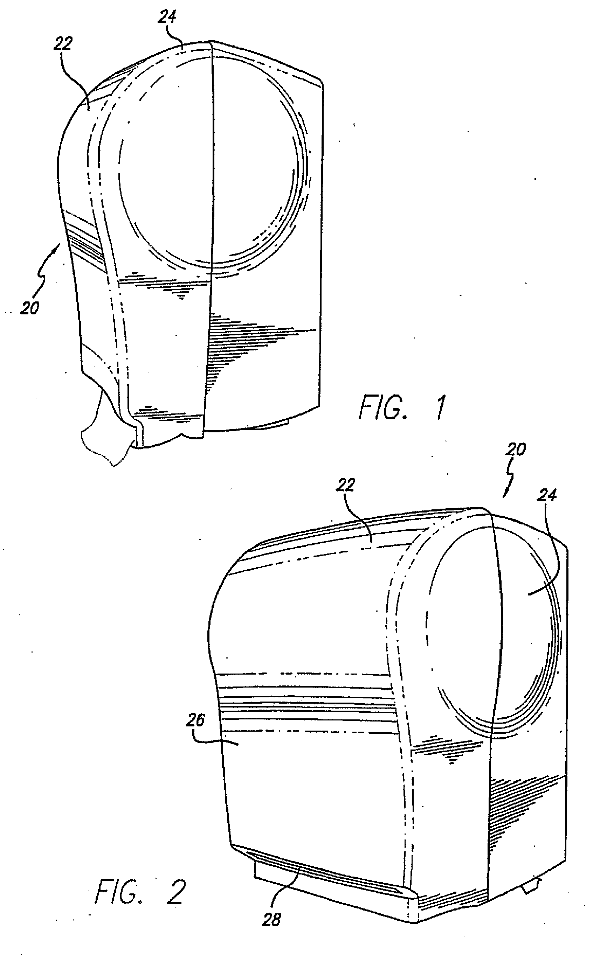

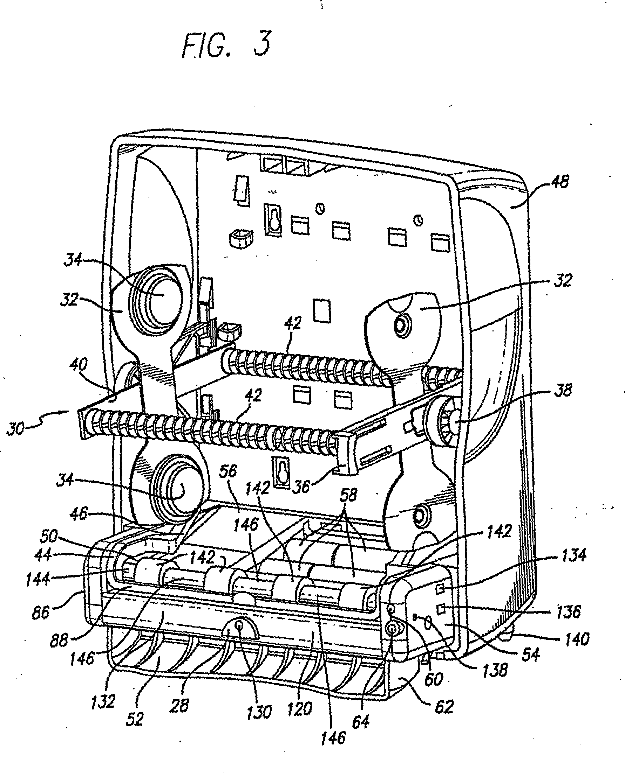

A side view, Figure 1, of the dispenser 20 with the cover 22 in place shows an upper circular bulge 24, providing room for a full roll of paper towel, installed in the upper position of the carousel. The shape of the dispenser is such that the front cover tapers inwardly towards the bottom to provide a smaller dispenser volume at the bottom where there is a smaller stub roll of paper towel. The shape tends to minimize the overall size of the dispenser. Figure 2 shows a perspective view of the dispenser 20 with cover 22 in place and the circular (cylindrical) bulge 24, together with the sunrise-like setback 26 on the cover 22, which tends to visually guide a hand toward the pseudo-button 28, leading to activation of a proximity sensor (not shown). A light emitting diode (LED) 130 is located centrally to the pseudo-button 28. The LED 130 (Fig. 3) serves as an indication that the dispenser 20 is on, and dispensing towel. The LED 130 may be off while the dispenser is not dispensing. Alternatively, the LED 130 may be lit (on), and when the dispenser 20 is operating, the LED 130 might flash. The LED 130 might show green when the dispenser 20 is ready to dispense, and flashing green, or orange, when the dispenser 20 is operating to dispense. Any similar combination may be used. The least power consumption is where the LED 130 only lights during a dispensing duty cycle. The sunrise-like setback 26 (Fig. 2) allows a hand to come more dosely to the proximity sensor (not shown).

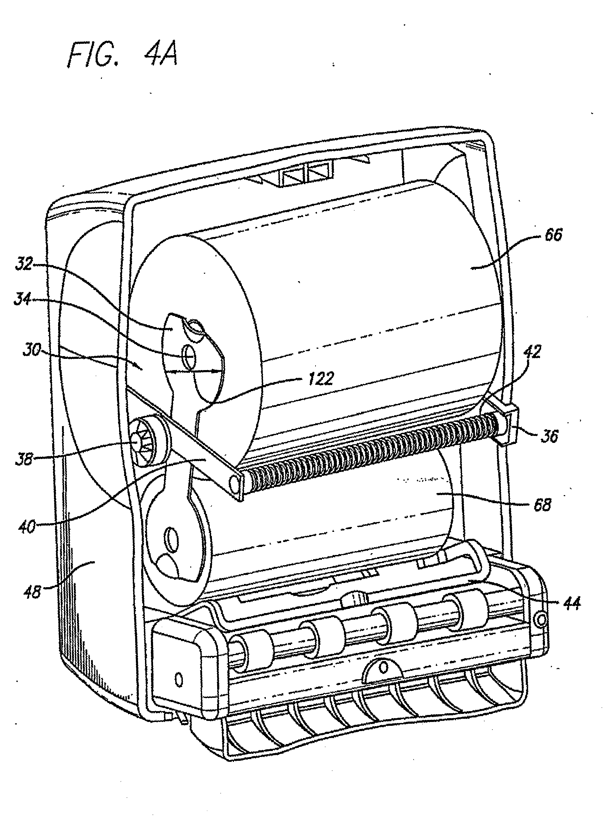

Figure 3 shows the main elements of the carousel assembly 30. The carousel arms 32 have friction reducing rotating paper towel roll hubs 34, which are disposed into the holes of a paper towel roll (66, 68, Fig. 4A). The locking bar 36 serves to lock and to release the carousel for rotation about its axis 38. The locking bar 36 rides on one of the corresponding bars 40. The two corresponding bars 40 serve as support bars. Cross-members 42 serve as stiffeners for the carousel assembly 30. and also serve as paper guides for the paper to be drawn over and down to the feed roller 50 and out the dispenser 20. These cross members are attached in a rigid fashion to the corresponding bars 40 and in this embodiment do not rotate.

The legs 46 of the transfer bar 44 do not rest against the friction reducing rotating paper towel roll hubs 34 when there is no stub roll 68 present but are disposed inward of the roll hubs 34. The bar part 88 of the transfer bar 44 will rest against a structure of the dispenser, for example, the top of modular electronics unit 132, when no stub roll 68 is present. The bar part 88 of the transfer bar 44 acts to bring the tail of a new main roll of paper towel 66 (Fig. 4A) down to the feed roller 50 which includes intermediate bosses 146 (Fig. 3) and shaft 144. The carousel assembly is disposed within the fixed casing 48. The cover is not shown.

Feed roller 50 serves to feed the paper towels 66, 68 (Fig. 4A) being dispensed onto the curved dispensing ribs 52. The curved dispensing ribs 52 are curved and have a low area of contact with the paper towel dispensed (not shown). If the dispenser 20 gets wet, the curved dispensing ribs 46 help in dispensing the paper towel to get dispensed by providing low friction and by holding he dispensing towel off of the wet surfaces it would otherwise contact.

The feed roller 50 is typically as wide as the paper roll, and includes drive rollers 142 and intermediate bosses 146 on the drive shaft 144. The working drive rollers or drive bosses 142 (Fig. 3) are typically an inch or less in width, with intermediate bosses 146 (Fig. 3) located between them. Intermediate bosses 146 are slightly less in diameter than the drive rollers or drive bosses 142, having a diameter 0.015 to 0.045 inches less than the drive rollers or drive bosses 142. In this embodiment, the diameter of the intermediate bosses 146 is 0.030 inches less than the drive roller 142. This configuration of drive rollers or drive bosses 142 and intermediate bosses 146 tends to prevent the dispensing paper towel from becoming wrinkled as is passes through the drive mechanism and reduces friction, requiring less power to operate the feed roller 50.

A control unit 54 operates a motor 56. Batteries 58 supply power to the motor 56. A motor 56 may be positioned next to the batteries 58. A light 60, for example, a light-emitting diode (LED), may be incorporated into a low battery warning such that the light 60 turns on when the battery voltage is lower than a predetermined level.

The cover 22 of the dispenser is preferably transparent so that the amount of the main roll used (see below) may be inspected, but also so that the battery low light 60 may easily be seen. Otherwise an individual window on an opaque cover 22 would need to be provided to view the low battery light 60. Another approach might be to lead out the light by way of a fiber optic light pipe to a transparent window in the cover 22.

In a waterproof version of the dispenser, a thin piece of foam rubber rope is disposed within a u-shaped groove of the tongue-in-groove mating surfaces of the cover 22 and the casing 48. The dispensing shelf 62 is a modular component, which is removable from the dispenser 20. In the waterproof version of the dispenser 20, the dispensing shelf 62 with the molded turning ribs 52 is removed. By removing the modular component, dispensing shelf 62, there is less likelihood of water being diverted into the dispenser 20 by the dispensing shelf 62, acting as a funnel or chute should a water hose or spray be directed at the dispenser 20, by the shelf and wetting the paper towel. The paper towel is dispensed straight downward. A most likely need for a waterproof version of the dispenser is where a dispenser is located in an area subject to being cleaned by being hosed down. The dispenser 20 has an on-off switch which goes to an off state when the cover 22 is pivoted downwardly. The actual switch is located on the lower face of the nodule 54 and is not shown.

In one embodiment, the user may actuate the dispensing of a paper towel by placing a hand in the dispenser's field of sensitivity. There can be adjustable delay lengths between activations of the sensor.

There is another aspect of the presence of water on or near the dispenser 20. A proximity sensor (not visible) is more fully discussed below, including the details of its operation. However, as can be appreciated, the sensor detects changes of capacitance such as are caused by the introduction of an object with a high dielectric constant relative to air, such as water, as well as a hand which is about 70% water. An on-off switch 140 is provided which may be turned off before hosing down and may be turned on manually, afterwards. The switch 140 may also work such that it turns itself back on after a period of time, automatically. The switch 140 may operate in both modes, according to mode(s) chosen by the user.

A separate "jog" off-on switch 64 is provided so that a maintenance person can thread the paper towel 66 by holding a spring loaded jog switch 64 which provides a temporary movement of the feed roller 50.

Figure 4A shows the dispenser case 48 with the carousel assembly 30 and transfer bar 44. The carousel assembly 30 is fully loaded with a main roll 66 and a stub roll 68, both mounted on the carousel arms 32 and rotate on the rotating reduced friction paper towel roll hubs 34 (only shown from the back of the carousel arms 32). In the carousel assembly 30, the two carousel arms 32, joined by corresponding bars 40 and cross members 42, rotate in carousel fashion about a horizontal axis defined by the carousel assembly rotation hubs 38. The locking bar 36 is supported, or carried, by a corresponding bar 40. The corresponding bar 40 provides structural rigidity and support. The locking bar 36 principally serves as a locking mechanism. Each paper towel roll 66, 68 has an inner cardboard tube which acts as a central winding core element, and which provides in a hole in paper towel roll 66, 68 at each end for engaging the hubs 34.

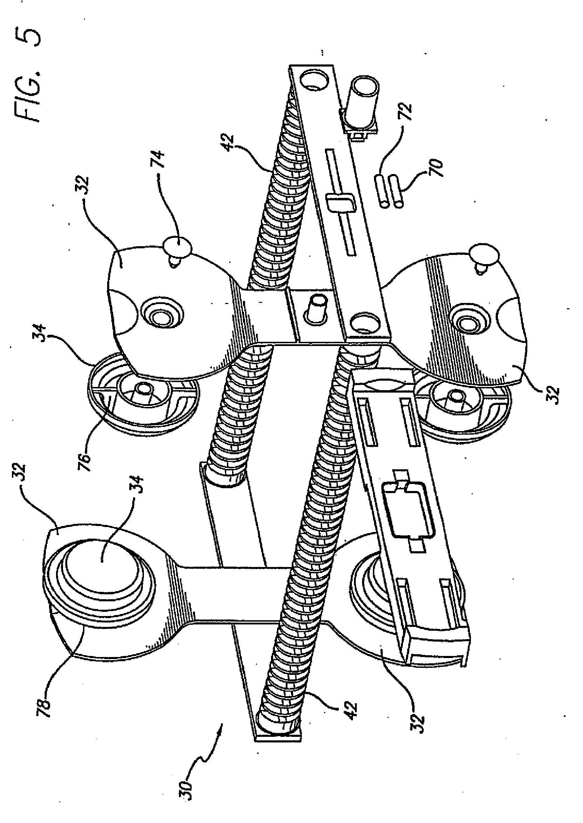

Figure 5 shows the carousel assembly 30 in exploded, perspective view. The number of parts comprising this assembly is small. From a reliability point of view, the reliability is increased. From a manufacturing point of view, the ease of manufacture is thereby increased and the cost of manufacture is reduced. The material of manufacture is not limited except as to the requirements of cost, ease of manufacture, reliability, strength and other requirements imposed by the maker, demand.

When the main roll, 66 (Fig. 4A) and the stub roll 68, (Fig. 4A) are in place, the carousel arms 32 are connected by these rolls 66 and 68 (Fig. 4A). Placing cross-members 42 to connect the carousel arms 32 with the locking 36 and corresponding 40 bar results in better structural stability, with racking prevented. The locking bar 36, which was shown as a single unit locking bar 36 in the previous figures, acts as a locking bar 36 to lock the carousel assembly 30 in the proper orientation. It acts also as the release bar, which when released, allows the carousel assembly 30 to rotate. Two compression springs 70, 72 are utilized to center the locking bar 36.

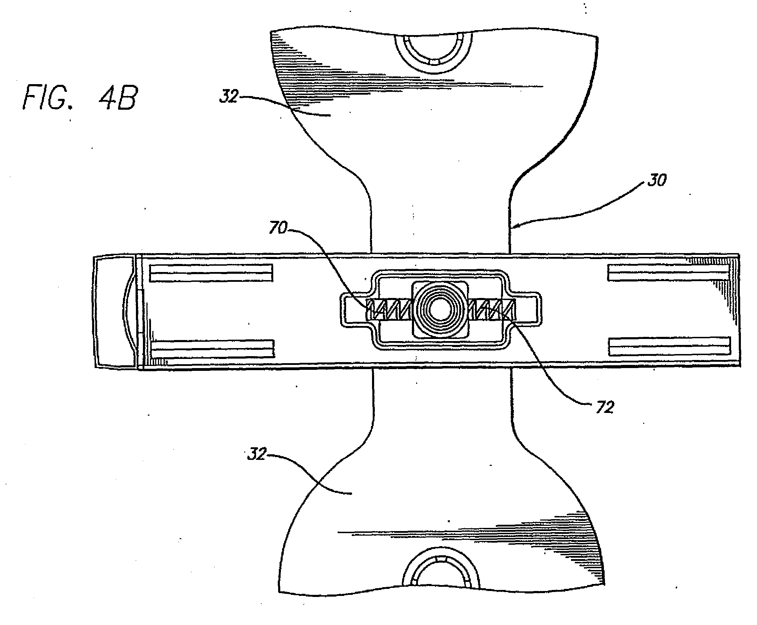

Figure 4B is a side view of the locking bar showing the placement of the compression springs. The compression springs 70, 72 also tend to resist the release of the locking bar 36, insuring that a required force is needed to unlock the locking bar 36. The required force is typically between 0.5lbf and 3.0 lbf, or more. In this embodiment, the force is 2.0lbf when the spring in a fully compressed position, and 1.1 lbf when the spring is in the rest position. In the rest position, the forces of the opposing springs offset each other.

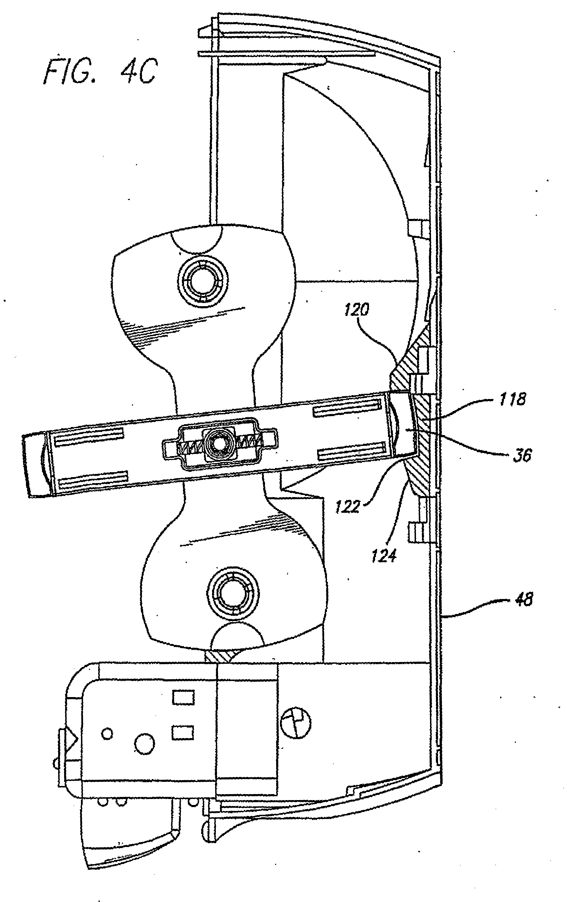

The actual locking occurs as shown in Figure 4C. The locking bar 36 closest to the rear of the casing 48 is adapted to fit into a generally u-shaped mating structure 118 which is adapted to hold the locking bar 36 and prevent it and the carousel assembly 30 from rotating. When the locking bar 36 is pulled away from the rear of the casing 48, the locking bar 36 is disengaged from the mating structure 118. The mating structure has an upper "high" side 120 and a lower "low" side 122, where the low side has a "ramp" 124 on its lower side. As the locking bar 36 is pulled out to clear the high side 120, the carousel assembly 30 is free to rotate such that the top of the carousel assembly 30 rotates up and away from the back of the casing 48. As the carousel assembly 30 begins to rotate, the user releases the locking bar 36 which, under the influence of symmetrically placed compression springs 70, 72 returns to its rest position. As he carousel assembly rotates, the end of the symmetrical locking bar 36 which originally was disposed toward the user now rotates and contacts the ramp 124. A locking bar spring, e.g., 70 or 72, is compressed as the end of the locking bar 36 contacting the ramp 124 now moves up the ramp 124. The end of the locking bar 36 is pressed into the space between the low side 122 and the high side 120, as the end of the locking bar 36 slides past the low side 122. A locked position for the carousel assembly 30 is now reestablished.

Figure 5 shows the carousel arms 32 adapted to receive the loading of a new roll of towel 66 (Fig. 4A). The arms 32 are slightly flexible and bent outward a small amount when inserting a paper towel roll 66 (Fig. 4A) between two opposite carousel arms 32. A friction reducing rotating paper towel roll hub 34 is inserted into a hole of a paper towel roll 66 (Fig. 4A), such that one roll hub 34 is inserted into a hole on each side of the paper towel roll 66 (Fig. 4A). Also shown in Figure 5 are the tamper resistant fasteners 74, which attach the friction-reducing rotating paper towel roll hubs 34 to the carousel arms 32.

Figure 5 shows the surface 76 of the roll hubs 34 and the surface 78 of the carousel arms 66, which contact each other. These contact surfaces 76, 78 may be made of a more frictionless material than that of which the carousel arms 32 and the roll hubs 34 are made. For example, a plastic such as polytetrafluoroethylene (PTFE), e.g., TEFLON, may be used, as a thin layer on each of the contacting surfaces. The paper towel dispenser 20 and its components may be made of, including but not limited to, plastic, metal, an organic material which may include but is not limited to wood, cardboard, treated or untreated, a combination of these materials, and other materials for batteries, paint, if any, and waterproofing.

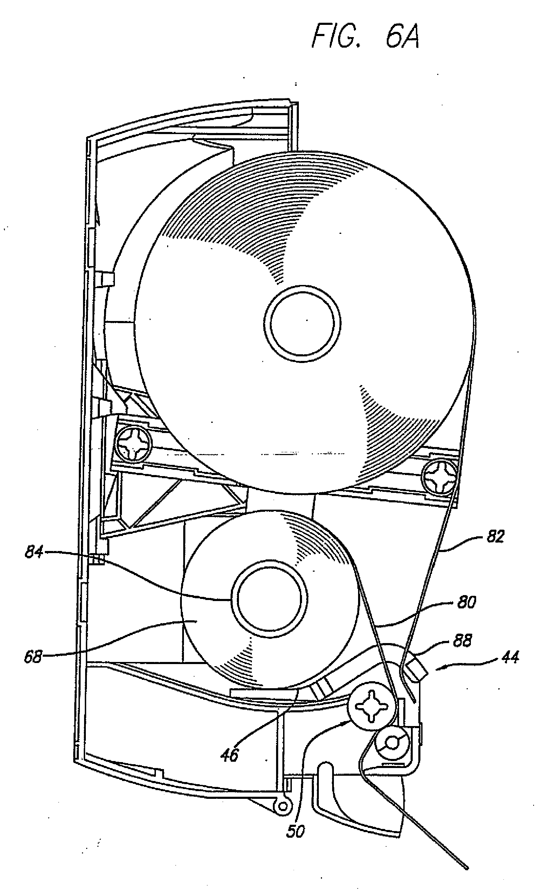

Figure 6A shows the paper 80 feeding from the stub roll 68 while the tail 82 of the main roll 66 is positioned beneath the transfer bar 44. The legs (visible leg 46, other leg not shown) of the transfer bar 44 rests against the stub roll. When the diameter of the stub roll 68 is larger by a number of winds of paper towel than the inner roll 84, the legs 46 of the transfer bar 44 dispose the bar 88 of the transfer bar 44 to be rotated upward from the feed roller 50.

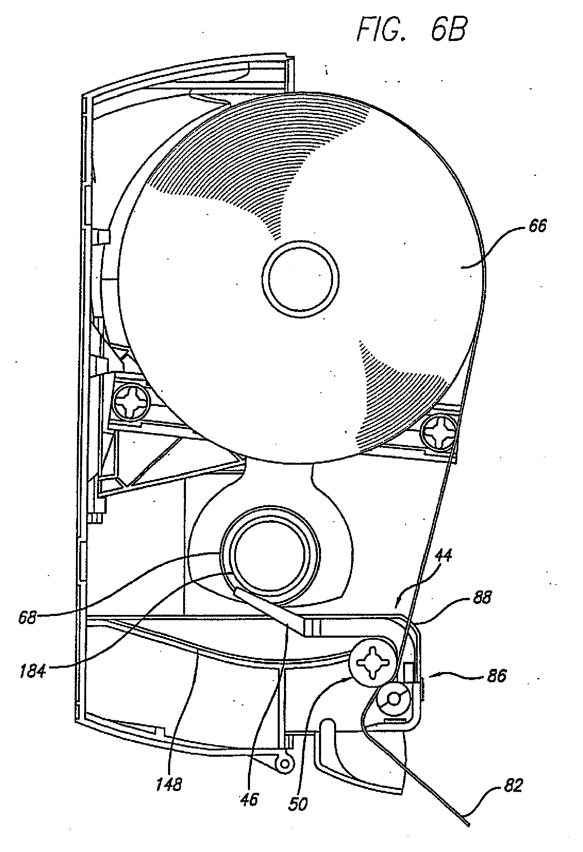

Figure 6B shows the situation where the stub roll 68 is exhausted, so that the transfer bar 44 tucks the tail 82 of the main roll 66 into the feed mechanism 86. Figure 6B shows the stub roll 68 position empty, as the stub roll has been used up. The stub roll core 84 is still in place. As the stub roll 68 is used up, the legs 46 of the transfer bar 44 move up toward the stub roll core (inner roll) 84, and the bar 88 of the transfer bar is disposed downward toward the feed roller 50 and toward the top of a structural unit of the dispenser 20 (Fig. 2), such as the top of the electronics module 132 (Fig. 3). Initially the main roll 66 is in reserve, and its tail 82 in an "idling" position such that it is under the transfer bar 44.. The main roll 66 and its tail 82 are not initially in a "drive" position. However, as the stub roll 68 is used up, the downward motion of the bar transfer bar, 44 driven by its spring loading, brings the bar 88 of the transfer bar 44 down to engage the main roll tail 82 with the feed roller 50.

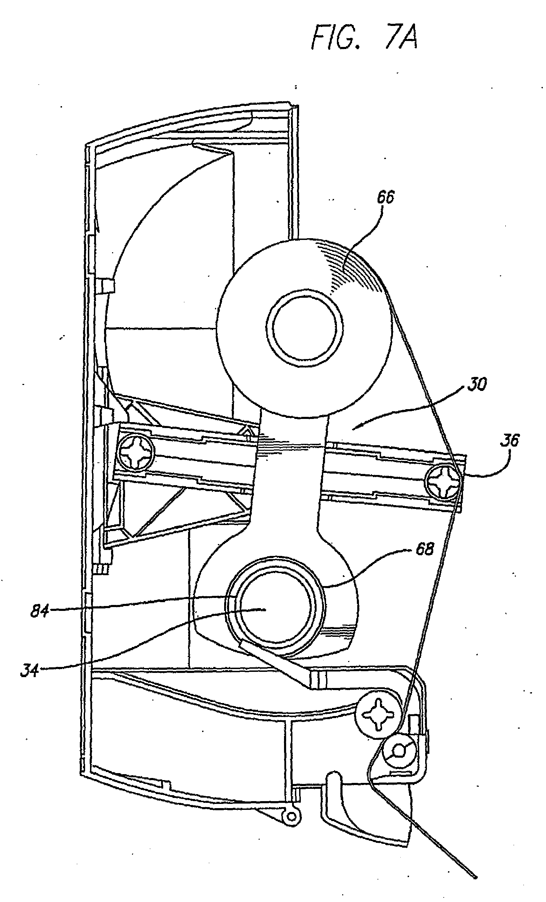

Figure 7A shows the carousel assembly 30 ready for loading when the main roll 66 reaches a specific diameter. The diameter of the main roll 66 may be measured by comparison of that diameter with the widened "ear" shape 122 (Fig. 4A) on each end of the carousel arms 32. That part of each carousel arm 32 is made to measure a critical diameter of a main roll 66. The carousel assembly 30 is tilted forward when it is locked. The carousel assembly 30 may rotate unassisted after the locking bar 36 is released, due to the top-heavy nature of the top roll. That is, the torque produced by the gravitational pull on the main-roll 66 is larger than that needed to overcome friction and the counter-torque produced by the now empty stub roll 68.

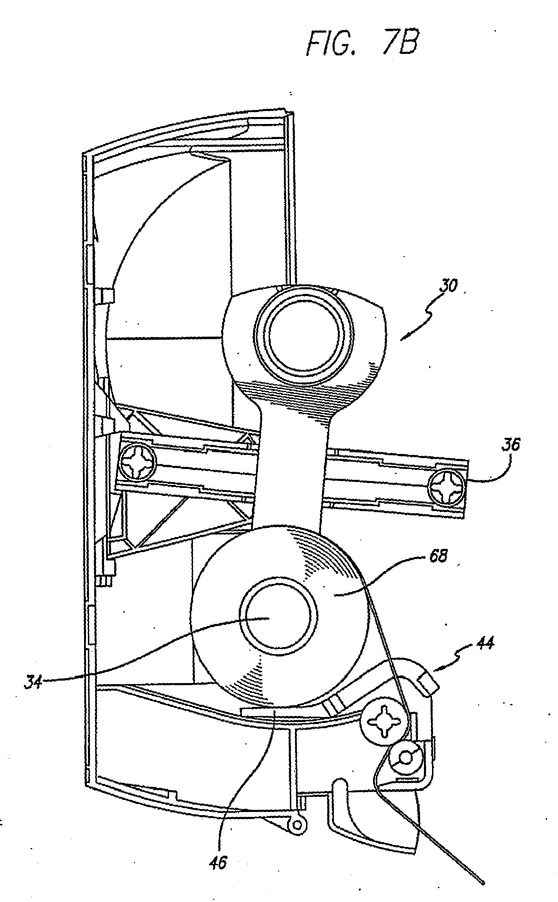

Figure 7B shows the process of loading where the service person pulls the locking bar 36 and allows the carousel to rotate 180E, placing the main roll 66 in the previous stub roll 68 position. Now a new full sized roll 66 can be loaded onto the main roll 66 position. The transfer bar 44 automatically resets itself. The transfer bar 44 is spring loaded so as to be disposed with the transfer bar legs 46 pressed upward against the stub roll 68 or the stub roll core 84. The transfer bar legs 46 are adapted to be disposed inward of the roll hubs 34 so the bar 88 of the transfer bar 44 will have a positive stop at a more rigid location, in this case, the top of the electronics module 132 (Fig. 2).

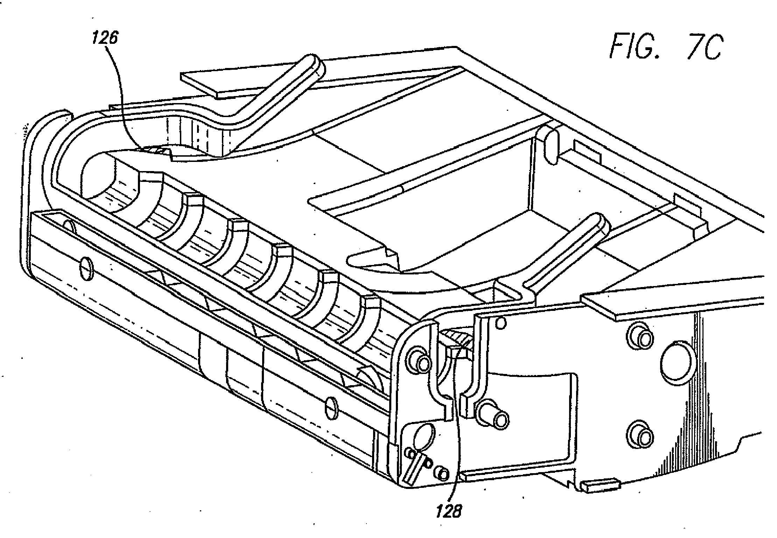

Figure 7C shows the extension springs 126, 128 which tend to maintain the transfer bar legs 46 in contact with the stub roll 68 or stub roll core 84. The transfer bar 44 contains the two extension springs 126, 128. The spring forces are typically 0.05 lbf to 0.5 lbf in the bar 44 lowered position and 0.2 lbf to 1.0 lbf in the bar 44 raised position. In this embodiment, the spring forces are 0.2 lbf in the lowered position an 0.43 lbf in the raised position. The force of the two springs 126,128 is additive so that the transfer bar 44 is subject to a total spring force of 0.4 lbf in the lowered position and 0.86 lbf in the raised position.

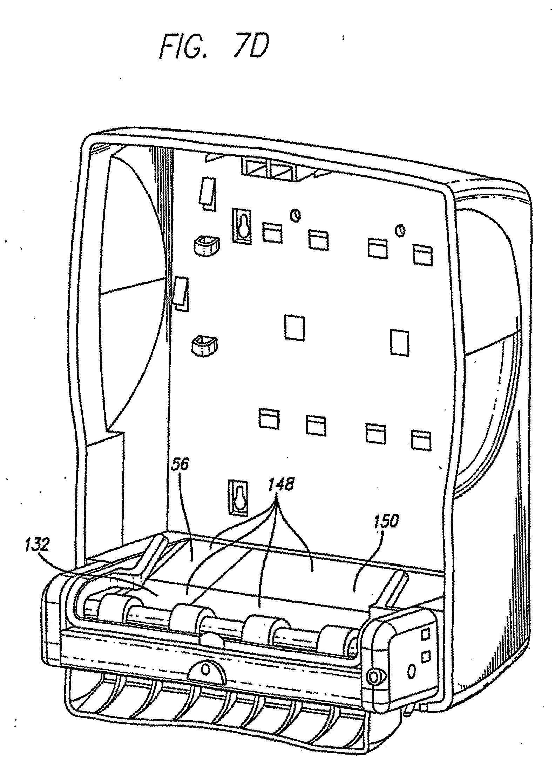

While modular units (Fig. 7D) such as the electronics module 132, the motor 56 module, and the battery case 150, are removable, they fit, or "snap" together so that the top of the electronics unit 132, the top of the motor 56 module and remaining elements of the "floor" 148 of the dispensing unit 20 form a smooth, cleanable surface. Paper dust and debris tend to accumulate on the floor 148 of the dispenser 20. It is important that the dispenser 20 is able to be easily cleaned as part of the maintenance procedure. A quick wiping with a damp cloth will sweep out and pick up any undesirable accumulation. The removable modular dispensing shelf 64 may be removed for rinsing or wiping.

The feed roller 50 may be driven by a motor 56 which in turn may be driven by a battery or batteries 58, driven off a 100 or 220V AC hookup, or driven off a transformer which is run off an AC circuit. The batteries may be non-rechargeable or rechargeable. Rechargeable batteries may include, but not be limited to, lithium ion, metal hydride, metal-air, nonmetal-air. The rechargeable batteries may be recharged by, but not limited to, AC electromagnetic induction or light energy using photocells.

A feed roller 50 serves to feed the paper towel being dispensed onto the curved dispensing ribs 52. A gear train (not visible) may be placed under housing 86, (Fig. 3) for driving the feed roller. A control unit 54 (Fig. 3) for a motor 56 (Fig. 3) may be utilized. A proximity sensor (not shown) or a hand-operated switch 64 may serve to turn the motor 56 on and off.

As an enhancement and further development of a system for delivering paper towel to the end user in as cost effective manner and user-friendly manner as possible. An automatic means for dispensing the paper towel is desirable, making it unnecessary for a user to physically touch a knob or a lever. Therefore, a more hygienic dispenser is present. This dispenser will contribute to less transfer of matter, whether dirt or bacteria, from one user to the next. The results of washing ones hands will tend to be preserved and hygiene increased.

An electronic proximity sensor is included as part of the paper towel dispenser. A person can approach the paper towel dispenser, extend his or her hand, and have the proximity sensor detect the presence of the hand. Upon detection of the hand, a motor is energized which dispenses the paper towel. It has long been known that the insertion of an object with a dielectric constant into a volume with an electromagnetic field will tend to modify the properties, which the electromagnetic field sees. The property of the hand, a dielectric constant close to that of water, is enough to alter the net capacitance of a suitable detector circuit.

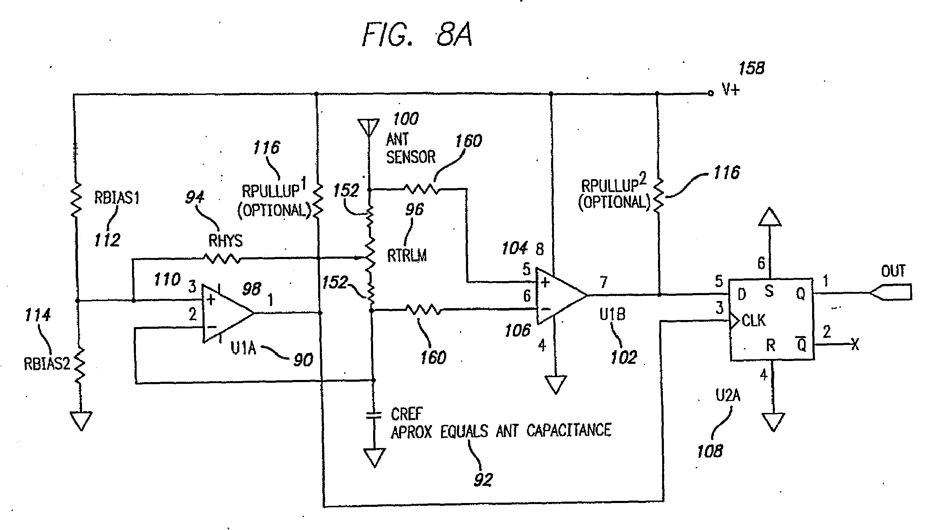

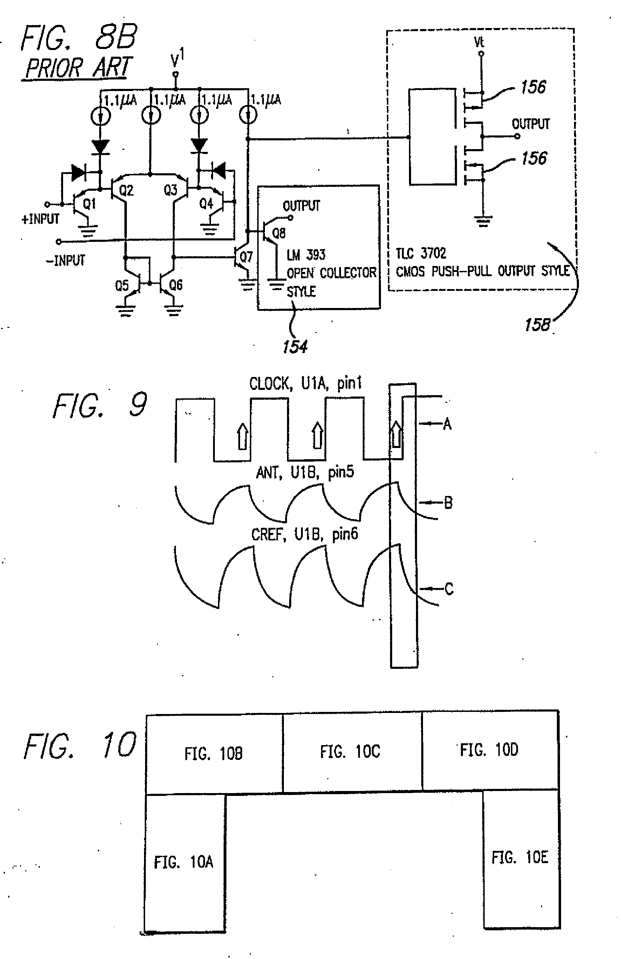

An embodiment of the invention comprises a balanced bridge circuit. See Figure 8A. The component U1A 90 is a comparator (TLC3702 158) configured as an oscillator. The frequency of oscillation of this component, U1A 90, of the circuit may be considered arbitrary and non-critical, as far as the operation of the circuit is concerned. The period of the oscillator is set by the elements Cref 92, Rhys 94, the trim resistance, Rtrim 96, where the trim resistance may be varied and the range resistors Rrange 152 are fixed. The resistors Rrange 152 allow limits to be placed on the range of adjustment, resulting in an easier adjustment. The adjustment band is narrowed, since only part of the total resistance there can be varied. Consequently a single potentiometer may be used, simplifying the adjustment of Rtrim 96. A value for Rrange 152 for the schematic shown in Figure 8A might be 100k$\Omega$. Rtrim 96 might have an adjustment range of 10k$\Omega$ to 50k$\Omega$. The output signal at pin1 98 of component U1A 90 is a square wave, as shown in Figure 9A. Cref 92 is charged by the output along with ANT 100, both sustaining the oscillation and measuring the capacitance of the adjacent free space. The signals resulting from the charging action are applied to a second comparator, U1 B 102, at pin5 104 and pin6 106 (Fig. 8A). These signals appear as exponential waveforms, as shown in Figure 9B and Figure 9C.

The simplest form of a comparator is a high-gain differential amplifier, made either with transistors or with an op-amp. The op-amp goes into positive or negative saturation according to the difference of the input voltages because the voltage gain is typically larger than 100,000, the inputs will have to be equal to within a fraction of a millivolt in order for the output not to be completely saturated. Although an ordinary op-amp can be used as comparator, there are special integrated circuits intended for this use. These include the LM306, LM311, LM393 154 (Fig. 8A), LM393V, NE627 and TLC3702 158. The LM393V is a lower voltage derivative of the LM393154. The LM393154 is an integrated circuit containing two comparators. The TLC3702 158 is a micropower dual comparator with CMOS push-pull 156 outputs. Figure 8B (prior art) is a schematic which shows the different output structures for the LM393 and the TLC3702. The dedicated comparators are much faster than the ordinary op-amps.

The output signal at pin1 98 of component U1A 90, e.g., a TLC3702 158, is a square wave, as shown in Figure 9. Two waveforms are generated at the inputs of the second comparator, U2B 102. The first comparator 90 is running as an oscillator producing a square-wave clocking signal, which is input, to the clock input of the flip-flop U2A 108, which may be, for example, a Motorola D flip-flop, No. 14013.

Running the first comparator as a Schmitt trigger oscillator, the first comparator U1A 90 is setup to have positive feedback to the non-inverting input, terminal3 110. The positive feedback insures a rapid output transition, regardless of the speed of the input waveform. Rhys 94 is chosen to produce the required hysteresis, together with the bias resistors Rbias1 112 and Rbias2 114. When these two bias resistors, Rbias1 112, Rbias2 114 and the hysteresis resistor, Rhys 94, are equal, the resulting threshold levels are 1/3 V+ and 2/3 V+, where V+ 158 is the supply voltage. The actual values are not especially critical, except that the three resistors Rbias1 112, Rbias2 114 and Rhys 94, should be equal, for proper balance. The value of 294kΩ may be used for these three resistors, in the schematic shown in Figure 8A.

An external pullup resistor, Rpullup1 116, which may have a value, for example, of 470Ω, is only necessary if an open collector, comparator such as an LM393 154 is used. That comparator 154 acts as an open-collector output with a ground-coupled emitter. For low power consumption, better performance is achieved with a CMOS comparator, e.g., TLC3702, which utilizes a cmos push-pull output 156. The signal at terminal3 110 of U1A charges a capacitor Cref 92 and also charges an ANT sensor 100 with a capacitance which Cref 92 is designed to approximate. A value for Cref for the schematic of Figure 8A, for the most current board design, upon which it depends, is about 10pF. As the clocking square wave is effectively integrated by Cref 92 and the capacltance of ANT 100, two exponential signals appear at terminal5 104 and terminal6 106 of the second comparator U1B, through the Rprotect 160 static protection resistors. Rprotect 160 resistors provide limiting resistance which enhances the inherent static protection of a comparitor input lines, particularly for the case of pin5 104 of U1 B 102. In the schematic shown in Figure 8A, a typical value for Rprotect 160 might be i2kΩ. One of the two exponential waveforms will be greater, depending upon the settings of the adjustable resistance Rtrim 96, Cref 92, and ANT 100. The comparator U1B 102 resolves small differences, reporting logic levels at its output, pin7 118. As the waveforms may initially be set up, based on a capacitance at ANT 100 of a given amount. However, upon the intrusion of a hand, for example, into the detection field of the antenna ANT 100, the capacitance of ANT 100 is increased significantly and the prior relationship of the waveforms, which were set with ANT 100 with a lower capacitance, are switched over. Therefore, the logic level output at pin7 118 is changed and the d flip-flop 108 state is changed via the input on pin5 of the D flip-flop 108.

The second comparator 102 provides a digital quality signal to the D flip-flop 108. The D flip-flop, U2A 108, latches and holds the output of the comparator U1B 90. In this manner, the second comparator is really doing analog-to-digital conversion. A suitable D flip-flop is a Motorola 14013.

The presence, and then the absence, of a hand can be used to start a motorized mechanism on a paper towel dispenser, for example. An embodiment of the proximity detector uses a single wire or a combination of wire and copper foil tape that is shaped to form a detection field. This system is very tolerant of non-conductive items, such as paper towels, placed in the field. A hand is conductive and attached to a much larger conductor to free space. Bringing a hand near the antenna serves to increase the antenna's apparent capacitance to free space, forcing detection.

The shape and placement of the proximity detector's antenna (Fig. 8A, 100) turns out to be of some importance in making the proximity sensor work correctly. Experimentation showed that a suitable location was toward the lower front of the dispenser unit. The antenna (Fig. 8A, 100) was run about two-thirds the length of the dispensing unit, in a modular, replaceable unit above the removable dispensing shelf 62 (Fig. 3). This modular unit would be denoted on Figure 3 as 120.

A detection by the proximity detection circuit (Fig. 8A) in the module 120 sets up a motor control flip flop so that the removal of the hand will trigger the start of the motor cycle. The end of the cycle is detected by means of a limit switch which, when closed, causes a reset of the flip-flop and stops the motor. A cycle may also be initiated by dosing a manual switch.

A wide range of sensitivity can be obtained by varying the geometry of the antenna and coordinating the reference capacitor. Small antennae have short ranges suitable for non-contact pushbuttons. A large antenna could be disposed as a doorway-sized people detector. Another factor in sensitivity is the element applied as Rtrim. If Rtrim 96 is replaced by an adjustable inductor, the exponential signals become resonant signals with phase characteristics very strongly influenced by capacitive changes. Accordingly, trimming with inductors may be used to increase range and sensitivity. Finally, circuitry may be added to the antenna 100 to improve range and directionality. As a class, these circuits are termed "guards" or "guarding electrodes," old in the art, a type of shield driven at equal potential to the antenna. Equal potential insures no charge exchange, effectively blinding the guarded area of the antenna rendering it directional.

The antenna design and trimming arrangement for the paper towel dispenser application is chosen for adequate range and minimum cost. The advantages of using a guarded antenna and an adjustable inductor are that the sensing unit to be made smaller.

From a safety standpoint, the circuit is designed so that a detection will hold the motor control flip-flop in reset, thereby stopping the mechanism. The cycle can then begin again after detection ends.

The dispenser has additional switches on the control module 54. Figure 3 shows a "length-of-towel-to-dispense-at-one-time" ('length')switch 134. This switch 134, is important in controlling how long a length of paper towel is dispensed, for each dispensation of towel. It is an important setting for the owner of the dispenser on a day-to-day basis in determining cost (to the owner) versus the comfort (to the user) of getting a large piece of paper towel at one time.

A somewhat similar second switch 136 is "time-delay-before-can-activate-the-dispensing-of another-paper-towel" ("time-delay") switch 136. The longer the time delay is set, the less likely a user will wait for many multiple towels to dispense. This tends to save costs to the owner. Shortening the delay tends to be more comfortable to a user.

A third switch 138 is the sensitivity setting for the detection circuit. This sensitivity setting varies the resistance of Rtrim 96 (Fig. 8A). Once an effective antenna 100 (Fig. 8A) configuration is set up, the distance from the dispenser may be varied. Typical actual use may require a sensitivity out to one or two inches, rather than four or six inches. This is to avoid unwanted dispensing of paper towel. In a hospital setting, or physicians office, the sensitivity setting might be made fairly low so as to avoid unwanted paper towel dispensing. At a particular work location, on the other hand, the sensitivity might be set fairly high, so that paper towel will be dispensed very easily.

While it is well known in the art how to make these switches according to the desired functionalities, this switch triad may increase the usefulness of the embodiment of this invention. The system, as shown in the embodiment herein, has properties of lowering costs, improving hygiene, improving ease of operation and ease of maintenance. This embodiment of the invention is designed to consume low power, compatible with a battery or battery pack operation. In this embodiment, a 6-volt DC supply is utilized. A battery eliminator may be use for continuous operation in a fixed location. There is a passive battery supply monitor that will turn on an LED indicator if the input voltage falls below a specified voltage.

A second embodiment of this invention comprises a second electronic proximity sensor. The second detector circuit is a miniaturized, micro-powered, capacitance-based proximity sensor designed to detect the approach of a hand to a towel dispenser. It features stable operation and a three-position sensitivity selector.

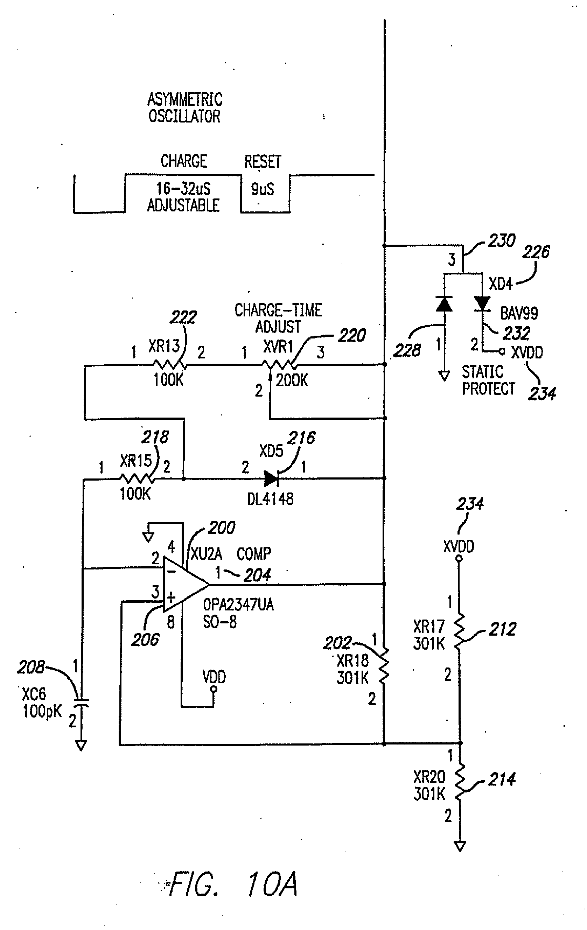

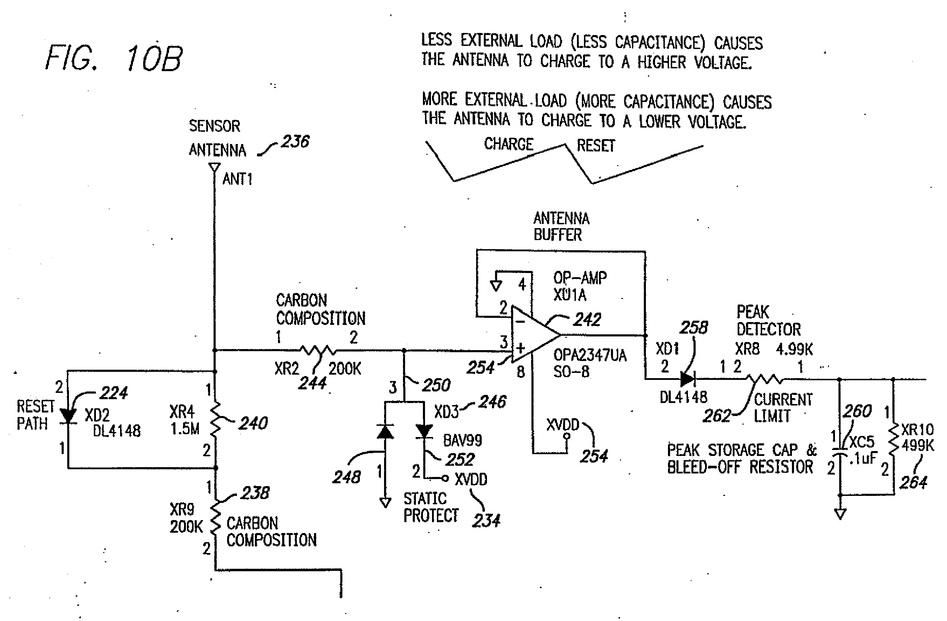

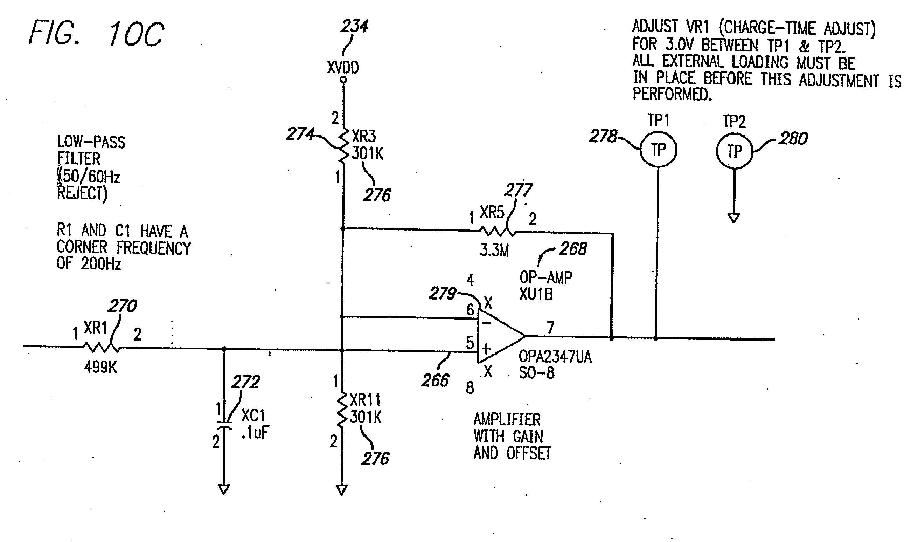

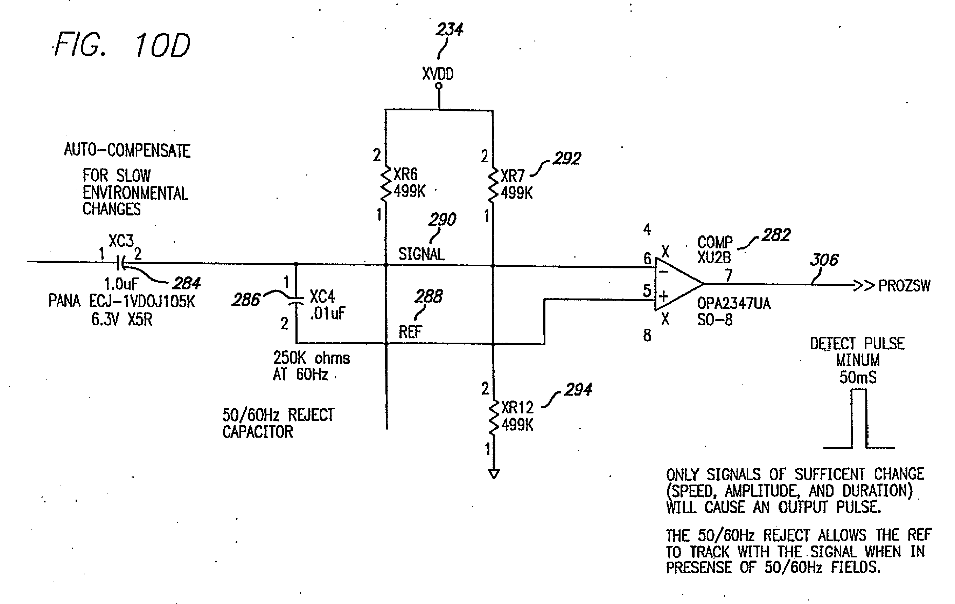

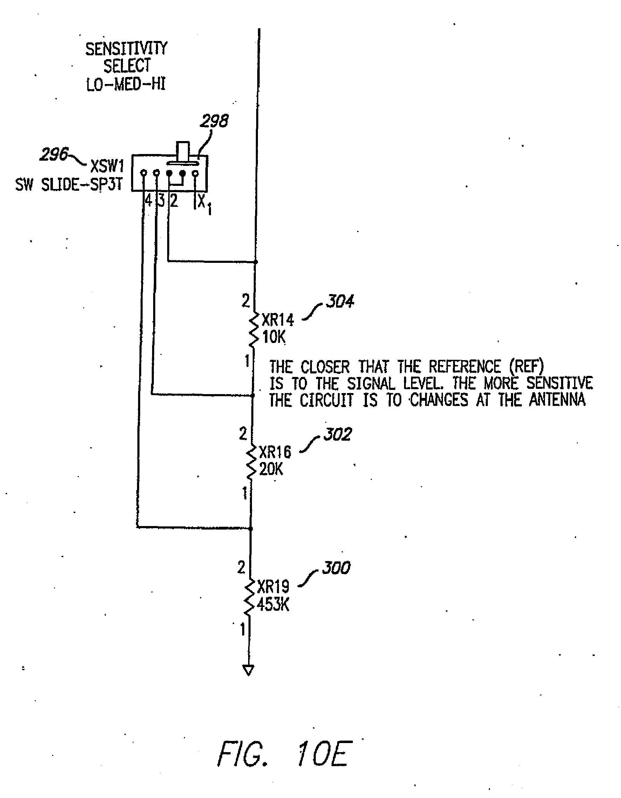

Figure 10 shows the whole proximity detector circuit. In order to examine the circuit more carefully, Figure 10 is broken out into sections 10A through 10E. These component circuits are shown separately as Figures 10A through 10E, corresponding to the breakout shown in Figure 10.

At the heart of the proximity detector is an adjustable asymmetric rectangular wave oscillator running in a range of 24kHz to 40kHz, as shown in Figure 10A. Once an initial adjustment has been set it is not readjusted during operation, normally. The asymmetrical feature of having a longer on-time and shorter off-time allows for more useable signal, i.e., on-time. This 24kHz to 40kHz oscillation range provides a basis for a high rate of sampling of the environment to detect capacitance changes, as detailed below. As shown, a fast comparator, XU2A 200, has positive feedback through XR18 202 from the output terminal1 204 (XU2A) to the positive input terminal3 206 (XU2A). The comparator operates as a Schmitt trigger oscillator with positive feedback to the non-inverting input, terminal. The positive feedback insures a rapid output transition, regardless of the speed of the input waveform. As the capacitor XC6 208 is charged up, the terminal3 206 of the XU2A 200 comparator reaches $2/3 \, XV_{DD}$. This voltage $2/3 \, XV_{DD}$ is maintained on terminal3 206 by the voltage dividing network XR17 212 and XR20 214, and the positive feedback resistor XR18 202 that is in parallel with XR17 212, where XR17 212 and XR20 214 and XR18 202 are all equal resistances. The simplest form of a comparator is a high-gain differential amplifier, made either with transistors or with an op-amp. The op-amp goes into positive or negative saturation according to the difference of the input voltages because the voltage gain is typically larger than 100,000, the inputs will have to be equal to within a fraction of a millivolt in order for the output not to be completely saturated. Although an ordinary op-amp can be used as comparator, there are special integrated circuits intended for this use. For low power consumption, better performance is achieved with a CMOS comparator, such as a TEXAS INSTRUMENT (trade-marked) TLC3702CD (trade-marked) 158 (Figure 8B). The TLC3702 158 is a micropower dual comparator with CMOS push-pull 156 (Figure 8B) outputs. These dedicated comparators are much faster than the ordinary op-amps.

As the transition occurs, the output, at the output terminal1 204, goes relatively negative, XD5 216 is then in a forward conducting state, and the capacitor XC6 208 is preferentially discharged through the resistance XR15 218 (100kΩ) and the diode XD5 216.

The time constant for charging the capacitor XC6 206 is determined by resistors XVR1 220, XR13 222 and XR15 218. The resistor XR15 218 and the diode XD5 216 determine the time constant for discharge of the capacitor XC6 208.

The reset time is fixed at $9\mu s$ by XD5 216 and XR15 218. The rectangular wave source supplying the exponential to the antenna, however, can be varied from $16\mu s$ to $32\mu s$, utilizing the variable resistance XVR1 220 and the resistors XR13 222 and XR15 218. Once set up for operational the variable resistance is not changed. The asymmetric oscillator can produce more signal ($16\mu s$ to $32\mu s$, as compared to the reset time. The reset time is not especially important, but the reset level is both crucial and consistent. The exponential waveform always begins one "diode voltage drop" (vbe) above the negative rail due to the forward biased diode voltage drop of XD2 224 (Figure 10B). One "diode voltage drop" (vbe) is typically in the range 0.5V to 0.8V, or typically about 0.6V.

The dual diode XD4 226 (Figure 10A) provides protection from static electricity. Terminal1 228 of XD4 226 will conduct when terminal3 230 is at least one diode voltage drop below the ground, or negative rail. Terminal2 232 will conduct when terminal3 230 is at least one diode voltage drop above VDD 234. Therefore, the signal level at terminal3 230 is limited to the range -vbe to VDD+vbe, thereby eliminating voltage spikes characteristic of "static", which may be induced by lightening or the operation of electrical motors, for example. The static is primarily built up by the internal mechanisms of the towel dispenser and the movement of the paper and is discharged by bringing a waving hand near the sensor.

The asymmetric square wave charges the antenna 236 (Figure 10B) through the resistors XR9 238 and XR4 240. The sum resistance, XR, is equal to XR9 238 plus XR4 240, or $1.7M\Omega$, for the example values shown in Figures 10 and 10B. The antenna 236 forms one conducting side of a capacitor, while the atmosphere and other materials form a dielectric between the antenna as one conducting element and other conductive materials including buildings and the actual earth as a second conductive element. The capacitance C of the antenna 236 relative to "free space" is approximately 7pF to 8pF, as determined by experiment, yielding a time constant $\tau$, where $\tau$ is equal to RC. Thus, the time constant, for the exemplary values, is about $13\mu s$.

If a hand of a person is placed in proximity to the antenna of the circuit, the capacitance of the antenna to free space may double to about 15pF with a resultant longer time constant and lower amplitude exponential waveform. The time constant $\tau$ is increased to about $26\mu s$. While it is possible to directly compare the signals, it is also desirable to have as stable an operating circuit as possible while retaining a high sensitivity and minimizing false positives and false negatives with respect to detection. To aid in achieving these goals, the signal is conditioned or processed first.

Looking at the operational amplifier XU1A 242, the (signal) waveform sees very high impedance, since operational amplifiers have high input impedance. The impedance on the antenna 236 side of the operational amplifier 242, in the form of resistance, is about $1.9M\Omega$. The impedance on the other side of the operational amplifier is of the order of $5k\Omega$. In order to provide an impedance buffer the signal the operational amplifier UX1A 242 is set up as a unity follower with a voltage gain of 1.0, that is, the gain given by $V_{out}/V_{in}$ equals one. The unity follower has an input-side (of the operational amplifier) resistance of about $1.0T\Omega$ ($10^{13}\Omega$). The (operational amplifier's) output impedance is in a range about 40 to 600 to several thousand ohms. Consequently, this unity follower configuration serves to isolate or buffer the upstream high-impedance circuit from the downstream low impedance circuit.

The resistor XR2 244 acts as a current limiter, since the current i is equal to v/XR2 at XR2 244. Further protection against static is provided by the diode pair XD3 246 in the same way as diode pair XD4 226 (Figure 10A). Terminal1 248 of XD3 246 will conduct when terminal3 250 is at least one diode voltage drop below the ground, or negative rail. Terminal2 252 will conduct when terminal3 250 is at least one diode voltage drop above VDD. Therefore, the signal level at terminal 3 250 is limited to the range -vbe to VDD+vbe, so that voltage spikes characteristic of "static" are eliminated.

Asymmetric oscillator pulses, after detecting capacitance which either includes or does not include a proximate dielectric equivalent to that of a proximate hand, act on the positive (non-inverting) input terminal 254 of the unity follower operational amplifier 242 to produce a linear output at its output terminal 256. The state of the output terminal is determined by first, the length of the asymmetric on pulse, and within the time of the "on" pulse, the time taken to charge up the antenna 236 (as capacitor) and the time to discharge through XR2 244 to the non-inverting input terminal 254. The time-constant-to-charge is $13\mu s$ to $26\mu s$. The time-constant-to-discharge is $0.8\mu s$ to $1.6\mu s$. To charge the antenna 236 to a certain charge, Q, for a capacitance based on a dielectric constant for "free space" of $\in_0$, i.e., $C\in_0$, a voltage of $V = Q/C\in_0$ is required. For the case of a capacitance, i.e., $C\in_0+\in$, which includes a detectable hand in "free space," the voltage required to store charge Q is $Q/C\in_0+\in$. However, $C\in_0+\in$ is about twice $C\in_0$, so that the voltage peak for the detected hand is about half of the no-hand-present case.

The diode XD1 258 allows positive forward conduction but cuts off the negative backward conduction of a varying signal pulse. The forward current, or positive peak of the current, tends to charge the capacitor XC5 260. The diode XD1 258, the resistor XR8 262, the capacitor XC5 260 and the bleed resistor XR10 264 comprise a peak detector network. XD1258 and XC5 260 capture the positive peak of the exponential waveform. XR8 262 prevents oscillation of XU1A 242. XR8 262 limits the charging time constant to 5ms, where XR8 262 is $4.99k\Omega$ and XC5 260 is $0.1\mu F$. This has an averaging effect on the peak detection and prevents noise spikes from pumping up the detector. The resistor XR10 264 discharges the detector at a half-second time constant.

When the hand is detected, the stored charge on XC8 260 is such that the voltage is sufficient to raise the input to the non-inverting terminal 266 of operational amplifier XU1B 268 above ½XVDD, so as to drive that operational amplifier output to a usable linear voltage range.

The combination of the resistor XR1 270 (e.g., 499kΩ) and the capacitor XC1 272 (e.g., 0.1 μF) comprise a low pass filter with a corner frequency of 1/XR1·XC1 (e.g., 24Hz), which corresponds to a time constant of XR1·XC1 (e.g., 50ms). This filter is for rejection of large 50Hz or 60Hz noise. These "high" frequencies are effectively shorted to ground. It is particularly helpful when the towel dispenser proximity detector is powered from an AC-coupled supply. The ubiquitousness of the AC power frequency, however, makes this protection desirable, regardless.

The signal is next amplified by an operational amplifier XU1B 268, which has a gain of 22. The resistor XR5 277 serves as a feedback resistor to the negative (inverting) input terminal 279 of the operational amplifier 268. There is a ½XV$_{DD}$ offset provided by the voltage divider network of XR3 274 and XR11 276. The output rests against the negative rail until a peak exceeds ½XV$_{DD}$. The charge time adjustment XVR1 becomes a very simple and sensitive way to adjust to this threshold. A setting of 3 V between test points XTP1 278 and XTP2 280 is recommended. This adjustment is made with all external capacitive loads (i.e., plastic and metal components) in place.

The output comparator 282 (Figure 10D) is connected to the signal processing from the operational amplifier 268 (Figure 10C) by the auto-compensate capacitor XC3 284 (Figure 10D). This makes the circuit insensitive to DC levels of signal, but sensitive to transients, e.g., a waving hand. As long as the charge-time adjustment function remains in a linear range, the sensitivity to a moving hand will be stable.

The capacitor XC4 286 allows the reference level (REF) 288 to track with approximately 50Hz or 60Hz noise on the SIGNAL 290 and not cause erroneous output pulses, since the AC noise will also track on the REF 288 (non-inverting) input to the comparator 282.

The output stage of the proximity detector is implemented as a variable threshold comparator, XU2B 282. The signal is set up with an offset voltage, where the resistors XR7 292 and XR12 294 are equal and divide the V$_{DD}$ voltage into two ½V$_{DD}$ segments. Three sensitivity settings are provided by SW1 296, high, medium, and low. These settings include where the reference voltage is the voltage drop across XR6 298 (499kΩ) with the remainder of the voltage divider equal to XR19 300 (453kΩ) plus XR16 302 (20kΩ) plus XR14 304 (10kΩ). This is the high setting, since the base reference voltage (V$_{DD}$·499/[499+483]) is greater than, but almost equal to the base signal value (V$_{DD}$·499/[499+499]). The signal must overcome, i.e., become smaller than the reference voltage (since the input is an inverting input) than the reference voltage, in order to swing the output 306 of the comparator XU2B 282 high and activate, say, a motor-control latch (not shown in Figure 10D). The medium sensitivity setting, in Figure 10E, of switch XSW1 296 (bypassing XR14, 304 10kΩ, by way of switch XSW1 296) widens the difference between the signal and reference levels. The low sensitivity setting (bypassing XR14 304, 10kΩ, and XR16 302, 20kΩ, by way of switch XSW1 296), widens that difference between the signal and reference levels even more. Consequently, a larger difference between the signal and the reference voltage must be overcome to activate the motor byway of the comparator XU2B 282 and the motor-control latch (not shown in Figure 10D).

The entire sensor circuit runs continuously on approximately 300μA at a supply voltage (XV$_{DD}$ 234) of 5V.

The most spectacular example of a build-up of static electric charge caused by mechanical separation of charge is the giant thunderstorm, with violent displays of lightning and the associated thunder. A more quiet but more pemicious static buildup problem is that associated with the destruction of electronic integrated circuit chips by unwanted static discharge to susceptible circuit leads. A common occurrence of the discharge of a mechanically-caused static charge buildup happens when a person becomes charged up walking on a rug on a dry, typically cold, day and has an unpleasant but non-injurious experience of discharging that charge by contacting a grounded object.

A similar situation occurs on a paper towel dispenser. Here, however, the separation of charge tends to be caused as a paper towel is separated from the main roll by being ripped-off along a guide bar, or a smooth or serrated blade. Some mechanical charge separation may also occur from the action of the paper towel web sliding along rib-structures and rollers of the dispenser. In many places where a paper towel dispenser is placed there is no, or no convenient access, to a ground wire or conduit of a 110V or 220 V electrical supply system or grounding rods or other ground-to-earth conductor.

Consequently, the approach of this invention is used instead. To ground static electricity buildup on a paper towel dispenser, a high conductivity grounding wire connects internal components of the dispenser that are subject to accumulating static electric charge. The high conductivity grounding wire connects to an electrical mechanical contact on the outside of the dispenser. A metal contact between the high conductivity pathway, and for example, the wall against which the dispenser is mounted, provides an electrical pathway for the dissipation of the static electrical build up on the dispenser to a local electrical ground.

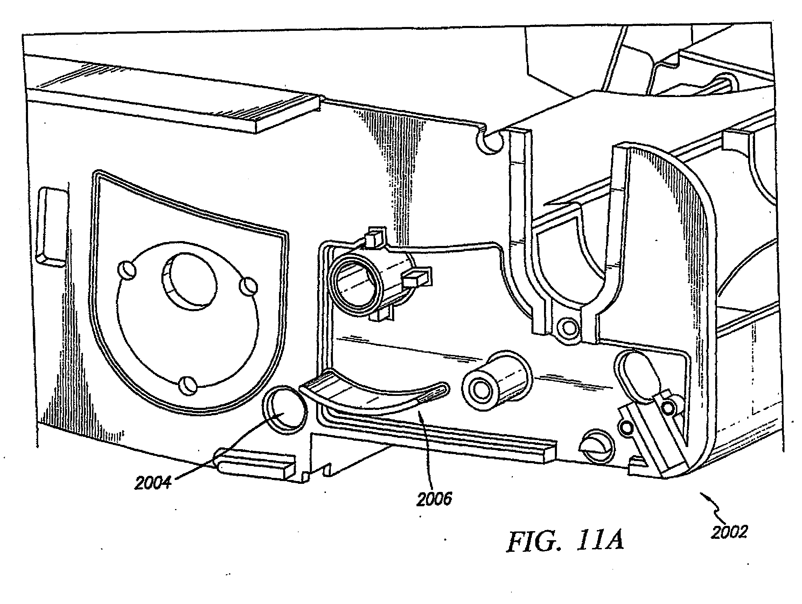

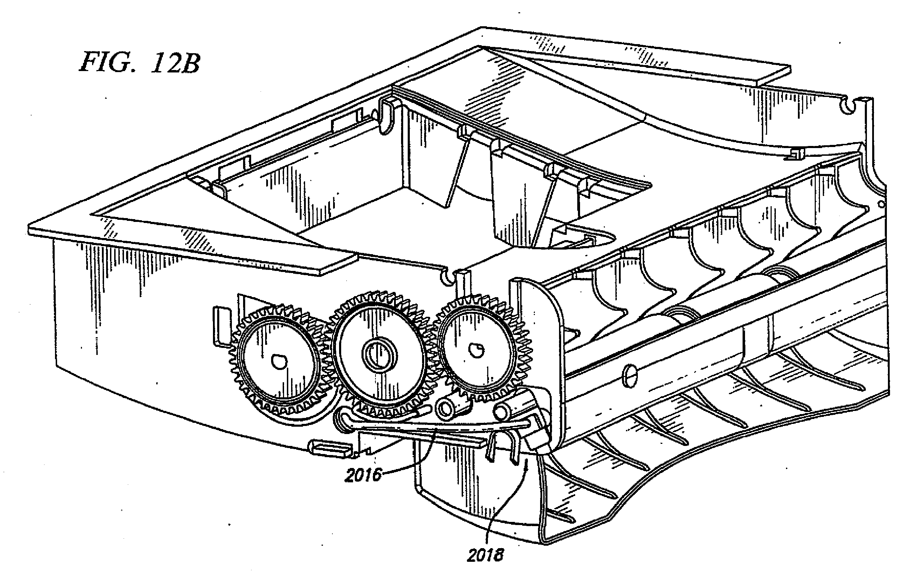

The first step is to provide a low impedance pathway for collecting the static electric charge on the dispenser and bringing it to a wall contact. Figure 11A shows a side of a paper towel dispenser 2002 with an access hole 2004 for the grounding wire (not shown) and shows a molded rib 2006 which prevents the low impedance grounding wire (not shown) from contacting an idler gear. The idler gear is not shown. This rib 2006 may be molded into the structure. The rib helps to route the grounding wire out of the way of a potentially interfering mechanism. The grounding wire 2016 may be seen in Figure 12B. The access hole provides a convenient entrance so as to allow the routing of the low-impedance grounding wire to the rear wall contact.

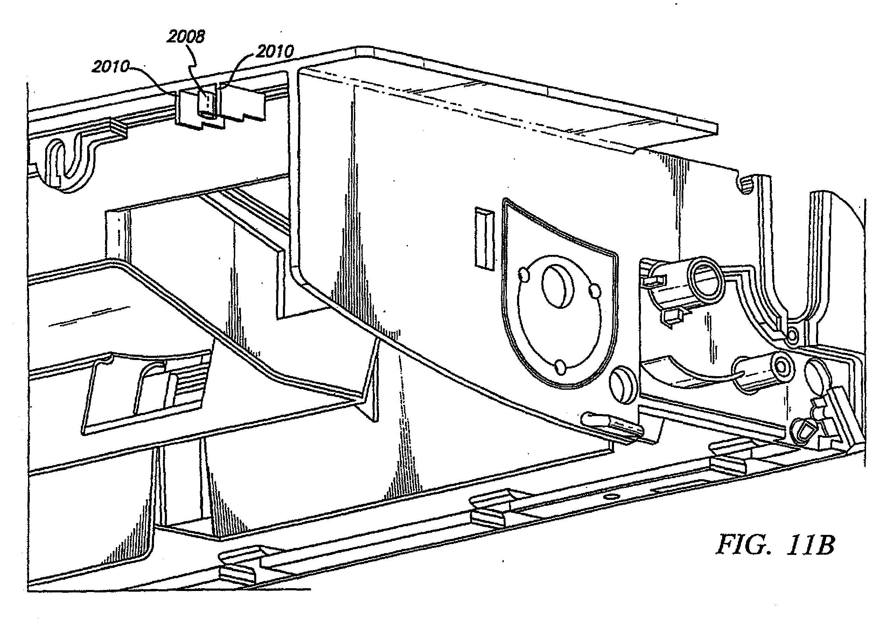

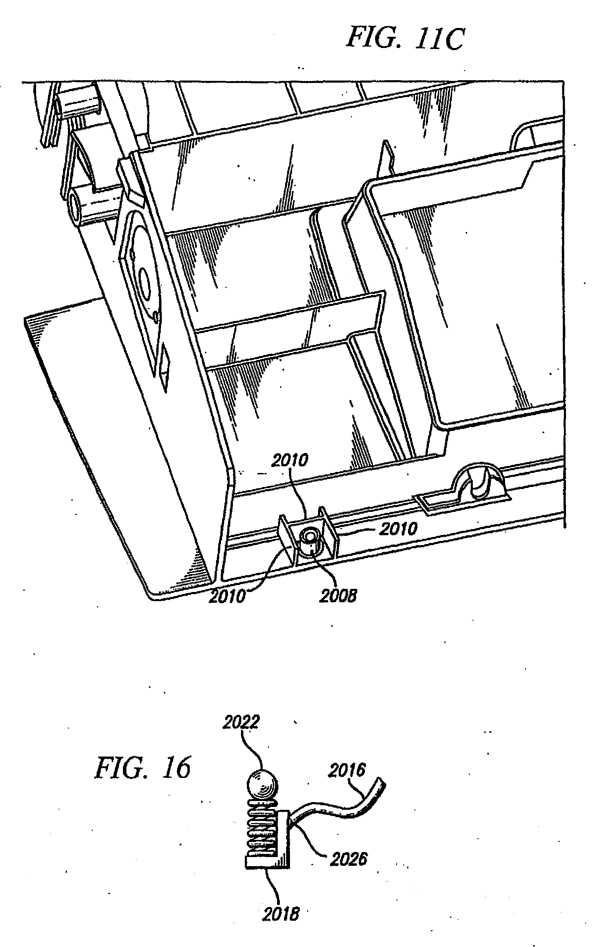

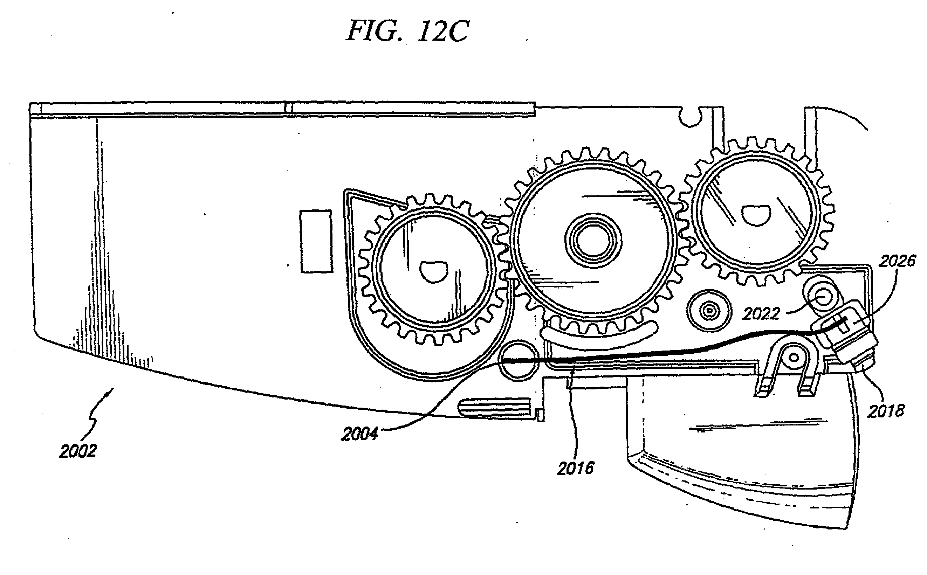

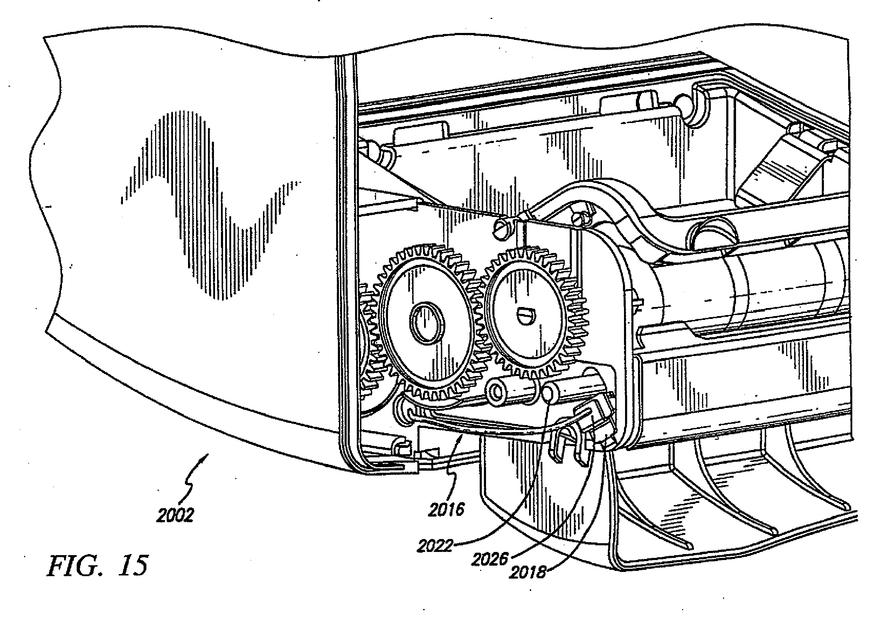

Features of the chassis structure provide an approach to securing both the grounding wire 2016 (Figures 12B, 12C, 15) to the rear wall contact 2020 (Figures 12C, 13, 14B) and securing the metal wall contact 2020 to the chassis of the dispenser. For the wall contact (not shown) there is a screw 2008 (Figure 11C) and ribs 2010 (Figure 11C) for attaching the wall contact to the chassis. This is seen in Figure 11B and in a different view from Figure 11C. The wall contact may be screwed to the chassis and the grounding wire secured to the wall contact with the same screw.

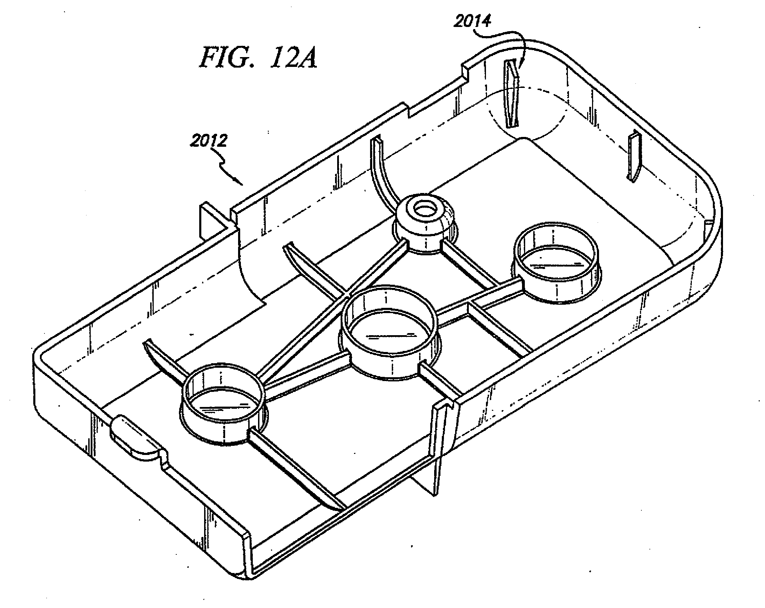

Since the nib rollers tend to pick up the initial static electric charge, the grounding wire is run from the nib rollers to the wall contact. Thus Figure 12A shows the gear cover 2012 with a rib 2014 molded into it, which holds the spring contact 2018 (Figures 12C, 13, 14B) in place. Keeping the grounding wire in a relatively straight line from the charge collection near the charge generation source allows a minimum length for the grounding wire 2016 (Figures 12B, 12C).

The actual contacting is of the grounding wire 2016 to a spring clip 2018, by a spring clip attachment means (2026, Figure 12C). The spring has a spring clip means as part of its structure. Figure 12B shows the grounding wire 2016 and its connection to the spring clip 2018 (Figures 12C, 13, 14B). A compression spring 2019 (Figure 16) contacts the metal nib roller shaft (2022, Fig. 15) by spring pressure, providing a mechanical and electrical contact. The static electricity accumulated on the nib rollers may transfer from the nib rollers to the metal nib roller shaft (2022, Figures 12B, 12C, 15). Then the static electricity may transfer through the spring clip 2018 to the grounding wire 2016. The ground wire 2016 is held by a spring clip means (2026, Fig.15) to the spring clip 2018 (Figures 12C, 13, 14B).

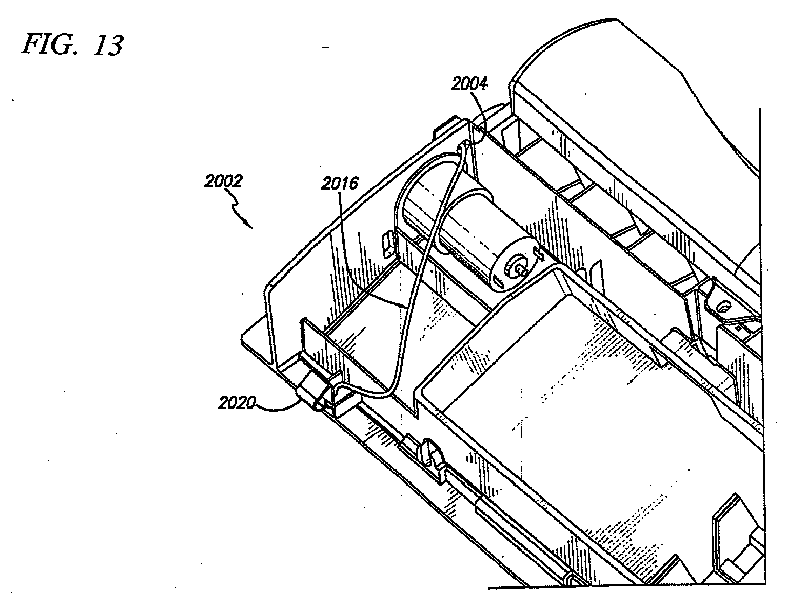

Figure 13 is a perspective view showing the wall contact spring grounding clip 2020 and the ground wire 2016, which is partially hidden as it enters the access hole 2004. The wall contact spring grounding clip 2020 is on the rear side of the paper towel dispenser. It is connected to the grounding wire 2016, which is hidden by part of the structure of the dispenser 2002. In Figure 12C, toward the front side of the dispenser 2002, the grounding wire 2016 is connected to the spring contact 2018 that electrically and mechanically connects to the nib roller shaft 2022 by spring pressure. As Figure 12C shows, the grounding contact runs from the nib roller (not shown) to the metal nib roller shaft 2022 through a spring clip 2018 (Figures 12C, 13, 14B). The ground contact continues through the grounding wire 2016 to the wall contact spring grounding clip 2020. When the dispenser 2002 is mounted on a wall, the wall contact spring grounding clip 2020, acting as a partially compressed spring, presses against the wall to maintain a mechanical pressure contact which provides an electrical conduction path to the wall from the static buildup areas on the towel dispenser 2002.

Figure 13 shows the pathway of the grounding wire 2016 from where it enters the access hole 2004 toward the interior of the dispenser 2002. The grounding wire 2016 continues until it contacts the wall contact spring grounding clip 2020. The ground wire 2016 is attached to the wall contact spring grounding clip 2020 by screw, bolt, soldering or other common methods of affixing a grounding wire to a metal contact which serves to complete a grounding path.

It may be appreciated that a dispenser may be made of alternative materials or combinations of materials. For example, in the case where the rear chassis of the dispenser is made of galvanized steel or stainless steel, the chassis itself may be formed with one or more integral spring wall contacts. The grounding wire, in these embodiments, may be attached by a means including, but not limited to, screw, bolt, soldering, brazing, or welding. In another embodiment, the rear chassis may be of a plastic, but having metal straps. These metal straps may also be formed with one or more integral spring contacts. The grounding wire may then be attached to the metal straps. Again, the dispenser may be made completely of metal, for example, stainless steel. In this embodiment, the grounding wire system may be used, or, the electrical grounding path may be from the spring contact, which presses against the nib roller, to the metal paper towel dispenser casing to the rear wall, by way of one or more integral spring wall contacts.

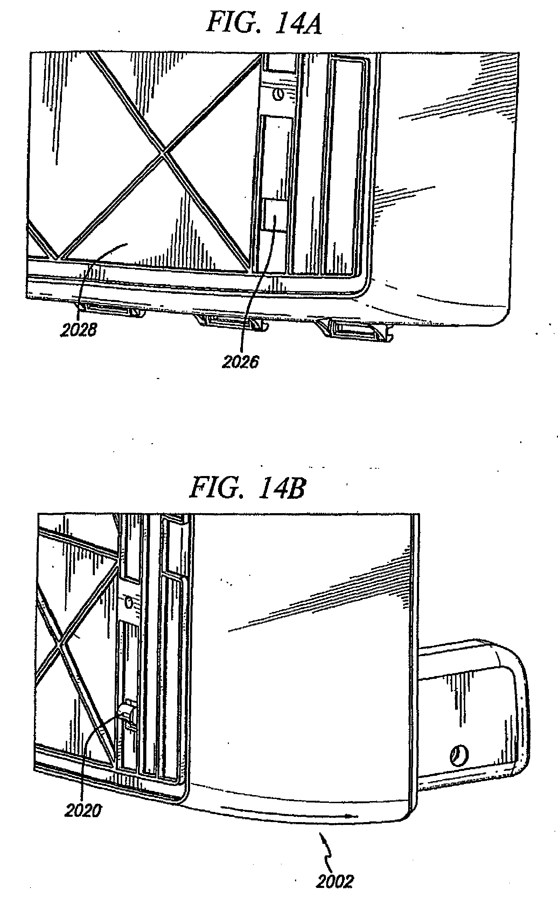

Figure 14A shows the opening 2026 in the rear cover 2028 for the wall contact spring grounding clip. The placement of the opening tends to be determined by keeping a shortest grounding wire, together with structural manufacturing considerations for the paper towel dispenser chassis.

Figure 14B shows the wall contact spring grounding clip 2020 in place, ready for the paper towel dispensing unit 2002 to be mounted in such a way as to press that wall contact spring grounding clip against the wall and maintain a good mechanical and electrical contact.

Figures 15 and 16 illustrate the dispenser 2002 with the front cover removed, shows further details of the connection from the nib roller (not shown) to the metal nib roller shaft 2022 and then through a spring contact 2018 which connects to the nib roller compression spring (not shown) and a spring clip attachment means 2026 connected to the grounding wire 2016 and to the wall contact spring grounding (not shown) clip to the wall (not shown).

The invention is further described in the following concluding paragraphs of this disclosure, which describe further additional aspects of the invention.

A first additional aspect of the invention is an apparatus for dispensing paper from rolls, which apparatus includes: means for holding and positioning at least first and second rolls of paper with respect to each other; means for dispensing paper from the first roll; means for dispensing paper from the first and second rolls simultaneously when the first roll reduces to a predetermined diameter of paper; means for positioning the depleted first roll for replacement without the necessity of removing the second roll; and, means for dispensing from the second and replacement rolls simultaneously when the second roll reduces to a predetermined diameter of paper.

A second additional aspect of the invention is a dispenser for a paper web roll. The dispenser includes: a first support adapted to hold a first roll of a paper; a second support adapted to hold a second roll of a paper; a third support rigidly connected to first and second support wherein the third support is rotatable about an axis; and, a transfer bar wherein paper from the second roll can be fed with paper from the first roll to dispense together.

Preferably, the dispenser of the second additional aspect of the invention further includes a housing having a cover rotatable to an open position; wherein the first, second and third supports are accessible when said housing cover is open.

Preferably, the dispenser of the second additional aspect of the invention further includes a locking bar wherein the third support is adapted to be disposed in a locked position by the locking bar, the locking bar being adapted to unlock the third support to allow said carousel assembly to rotate about the axis. More preferably, the third support is biased to rotate when unlocked.

Preferably, the transfer bar further includes two legs adapted to contact opposite ends of a stub roll, to contact opposite ends of a stub roll core tube when said stub roll is used up and only the core tube remains and wherein the two legs are joined by an elongated bar. More preferably, the dispenser includes: a feed roller for driving paper from the rolls. The transfer bar is rotatably disposed with its elongated bar adjacent to the feed roller and the legs of the transfer bar adjacent to the rotatable roll hubs when the stub roll is in position. Even more preferably, the dispenser further includes: a nib roller disposed to operate with the feed roller to drive paper from the rolls between the feed and nib rollers.

A third additional aspect of the invention is a dispenser for a paper web roll, the dispenser including: a first support for a first roll of a paper; a second support for a second roll of a paper; and, a third support for said first and for said second support, the third support being rotatable about an axis; a feed roller; nib roller disposed to operate in concert with the feed roller; a drive mechanism to drive the feed roller to dispense paper towel disposed between the feed and nib rollers. More preferably, the dispenser further includes: a transfer bar adapted to simultaneously feed paper from the first and second rolls. Even more preferably, the transfer bar further includes two legs adapted to contact opposite ends of a stub roll, to contact opposite ends of a stub roll core tube when said stub roll is used up and only the core tube remains, the two legs being joined by an elongated bar. Even still more preferably, the dispenser further includes a feed roller for driving paper from the rolls, wherein the transfer bar is rotatably disposed with its elongated bar adjacent to the feed roller and the legs of the transfer bar adjacent to the rotatable roll hubs when the stub roll is in position. Even further preferably, the third support is biased to rotate when unlocked. Further more preferably, the dispenser further includes a locking bar, wherein the third support is adapted to be disposed in a locked position by the locking bar, the locking bar being adapted to unlock the third support to allow the carousel assembly to rotate about the axis. Even more preferably, the dispenser further includes a housing having a cover rotatable to an open position; wherein the first, second and third supports are accessible when the housing cover is open.

A fourth additional aspect of the invention is a method for dispensing paper from a roll. The method includes the steps of: supporting a first roll of a paper in a first position; supporting a second roll of a paper web in a second position; rotating secured first and second rolls between the first and second positions about a horizontal; and simultaneously dispensing paper from the first and second rolls. Preferably, the method further includes the steps of: locking the rolls so that they are unable to rotate between the first and second position; and, unlocking the rolls so that they are free to rotate about the horizontal axis. Even more preferably, the method further includes the step of biasing the first roll to rotate when unlocked. Even still further, the method further includes the step of positioning two legs of a transfer bar to contact opposite ends of a stub roll and to contact opposite ends of a stub roll core tube when said stub roll is used up and only the core tube remains; and, joining the two legs joined by an elongated bar. Yet still further, the method includes the steps of: utilizing a feed roller for driving paper from the rolls, wherein the transfer bar is rotatably disposed with its elongated bar adjacent to the feed roller and said legs of said transfer bar adjacent to said rotatable roll hubs when the stub roll is in position. Even yet still further, the method includes the steps of: utilizing a nib roller disposed to operate with said feed roller to drive paper from the rolls between the feed and nib rollers.

A fifth additional aspect of the invention is a method that includes the steps of: supporting a first roll of paper on a first support; supporting a second roll of paper roll on a second support; supporting said first and second supports with a third support, wherein the third support is rotatable about a horizontal axis; and, dispensing paper towel between a feed roller and a nib roller. More preferably, the method includes the step of utilizing a transfer bar, wherein the second roll can be fed with the first roll to dispense together. The method may even more preferably include the steps of: positioning two legs of a transfer bar to contact opposite ends of a stub roll and to contact opposite ends of a stub roll core tube when the stub roll is used up and only the core tube remains; and, joining the two legs joined by an elongated bar. The method may still more preferably include the step of utilizing a feed roller for driving paper from the rolls, wherein the transfer bar is rotatably disposed with its elongated bar adjacent to the feed roller and the legs of the transfer bar adjacent to the rotatable roll hubs when the stub roll is in position. Even more preferably, the method further includes the step of biasing the first roll to rotate when unlocked. Still yet more preferably, the method includes the steps of: locking the rolls so that they are unable to rotate between the first and second position; and, unlocking the rolls so that they are free to rotate about the horizontal axis.

A sixth additional aspect of the invention is a proximity detection circuit that includes: an oscillator circuit having a period set by a hysteresis resistor, a variable trim resistor and, a reference capacitor; a balanced bridge comprising a sensor having a capacitance on one arm of said bridge and a reference capacitor on the other arm of the bridge, wherein the variable trim resistor is adapted to adjust voltage amplitudes on each arm of said bridge; a comparator adapted to compare the voltages across each arm of said bridge, and provide an output voltage; and, an edge-triggered d flip-flop which latches and holds on the leading edge of the comparator output voltage. The circuit more preferably includes a motor activation switch connected to receive an output of the flip-flop.

A seventh additional aspect of the invention includes: an oscillator circuit including a first comparator adapted to provide a clock signal as an output; a sensor having a capacitance; a reference capacitor adapted to approximately balance the sensor's capacitance, one side of the reference capacitor being connected to ground; a variable trim resistance in series between the sensor's capacitance and the reference capacitor; a hysteresis resistor adapted, in conjunction with the variable trim resistor and the reference capacitor, to set the oscillation frequency of the oscillator; a second comparator adapted to compare voltages at its two input pins as measured across the variable trim resistor; and, an edge-triggered d flip-flop adapted to latch and hold the output of the second comparator, said flip-flop being clocked by output signal of first comparator.

An eighth additional aspect of the invention is a method for detecting small capacitance changes, which method Includes the steps of: producing voltage oscillations in a first comparator comprising an oscillator with a period set by a hysteresis resistor, a variable trim resistor and a reference capacitor; forming a balance bridge of two arms, the first arm comprising a sensor with capacitance and the second arm comprising the reference capacitor; comparing voltages from each arm of a balanced bridge, whereby the variable trim resistance adjusts voltage amplitudes in each arm of said bridge; detecting a first voltage amplitude at a location between the sensor and the variable trim resistor, the first voltage being applied to the positive input pin of the second comparator; detecting a second voltage at a location between the reference capacitor and the capacitor, the second voltage being applied to the negative input pin of the second comparator; providing an output voltage at the output pin of the second comparator, the output voltage of the second comparator being adapted to become low when the amplitude of the first voltage is lower than the amplitude of the second voltage; latching and holding on the leading edge of the second comparator output voltage utilizing an edge triggered d flip-flop; and, reversing an output state of said flip flop when an object having an increased dielectric constant over the dielectric constant of air is sensed, said object increasing the capacitance in the sensor arm of the balanced bridge and changing the amplitude of said first voltage. Preferably, the method further includes the step of activating a motor switch when detecting a change in the output state of the flip-flop.

A ninth additional aspect of the invention is a method for detecting small capacitance changes, utilizing a proximity detection circuit, including the steps of: producing voltage oscillations in a first comparator adapted as an oscillator, with a period set by a hysteresis resistor, a variable trim resistor and a reference capacitor; forming a balance bridge of two arms, with a first arm comprising a sensor with capacitance and a second arm comprising the reference capacitor; balancing, approximately, a sensor's capacitance with the reference capacitor, said reference capacitor having one side connected to ground; setting a variable trim resistance, wherein said trim resistance is in series between the sensor's capacitance and the reference capacitor; setting the oscillation frequency of the oscillator utilizing a hysteresis resistor, the reference capacitor and a setting of the variable trim resistor; detecting a first voltage at a location between the sensor and the variable trim resistor; applying a first voltage to the positive input pin of the second comparator; detecting a second voltage at a location between the reference capacitor and the capacitor; applying a second voltage to the negative input pin of the second comparator; producing a low output state of the second comparator when the first voltage amplitude is lower than the second voltage amplitude; producing a high output state of the second comparator when the first voltage amplitude is higher than the second voltage amplitude; applying the output voltage at the output pin of the second comparator to a an edge triggered d flip-flop; latching and holding the output of the second comparator utilizing an edge-triggered flip-flop; clocking said flip-flop by the oscillator output signal of first comparator; and, sensing an increased dielectric constant when an object enters in the sensor's detection field, the object entering the field causing an effective capacitance of the sensor to increase, and the amplitude of said first voltage to change to thereby cause the output of the second comparator to change state. Preferably, the method includes the additional step of activating a motor switch when detecting a change in the output state of the flip-flop.

A tenth additional aspect of the invention is an apparatus for dispensing paper from rolls, the apparatus including: means for holding and positioning at least first and second rolls of paper with respect to each other; means for dispensing paper from the first roll; means for dispensing paper from the first and second rolls simultaneously when the first roll reduces to a predetermined diameter of paper; means for positioning the depleted first roll for replacement without the necessity of removing the second roll; means for dispensing from the second and replacement rolls simultaneously when the second roll reduces to a predetermined diameter of paper; and, a proximity detector adapted to trigger the dispensing means when a user's hand is positioned within the field of the sensor. Preferably, the proximity detector further includes: an oscillator circuit with a period set by a hysteresis resistor, a trim resistor and a reference capacitor; a balanced bridge with a one arm of said bridge having a sensor having a capacitance and the other arm of the bridge having a reference capacitor, the variable trim resistance being adapted to adjust voltages on each arm of said bridge; a second comparator adapted to compare the voltages across each arm of said bridge; and, an edge-triggered d flip-flop which latches and holds on the leading edge of the second comparator output voltage.

An eleventh additional aspect of the invention is a dispenser for a paper web roll, the dispenser including: a first support adapted to hold a first roll of a paper; a second support adapted to hold a second roll of a paper; a third support rigidly connected to first and second support wherein said third support is rotatable about an axis; a transfer bar wherein paper from said second roll can be fed with paper from the first roll to dispense together; a proximity detector adapted to trigger the dispensing of paper when a user's hand is positioned within the field of the sensor. The detector includes: an oscillator circuit comprising a first comparator adapted to provide a clock signal as an output; a sensor having a capacitance; a reference capacitor adapted to approximately balance the sensor's capacitance, one side of the reference capacitor being connected to ground; a variable trim resistance connected in series between the sensor's capacitance and the reference capacitor; a hysteresis resistor adapted to set the oscillation frequency of the oscillator together with the variable trim resistor and the reference capacitor; and, a second comparator adapted to compare voltages at the two input pins of the second comparator as measured across the variable trim resistor; and, an edge-triggered d flip-flop adapted to latch and hold the output of the second comparator, the flip-flop being clocked by output signal of the first comparator. Preferably, the dispenser further includes means for providing a selectable dispensed paper length, the means including: motor means for dispensing paper from at least one roll; a first motor control sub-circuit; a first switch adapted to control the first sub-circuit, the first sub-circuit being adapted to set the length of paper dispensed by said motor means according to the setting of the first switch. The dispenser in this aspect of the invention may further include means for providing a selectable time delay before dispenser can be reactivated to dispense another length of paper. The means includes: motor means for dispensing paper from at least one roll; a second motor control sub-circuit; a second switch adapted to control the second sub-circuit, the second sub-circuit being adapted to set a time delay for paper dispensed by said motor means according to the setting of the second switch. Preferably, the dispenser further includes means for providing a selectable sensitivity of the proximity sensor, the means including: a variable capacitor in a leg of the balanced capacitance bridge-based proximity detector; a third switch adapted to control the variable capacitor, said variable capacitor being adapted to set sensitivity of the balanced capacitance bridge-based proximity. Preferably, the dispenser further includes means for providing an eye-hand-brain guidance, the guidance being adapted to guide a hand toward the dispenser's proximity sensor; the means includes: a pseudo-button disposed within a sunrise-like setback on the cover, the pseudo-button being positioned near the proximity sensor, said sunrise-like setback and the pseudo-button being adapted to focus a user's visual field so that a user tends to guide their hand toward the pseudo-button.

A twelfth additional aspect is a method for dispensing paper from a roll upon detecting small capacitance changes by a proximity sensor from a hand or like object placed near the dispenser. The method includes the steps of: supporting a first roll of a paper in a first position; supporting a second roll of a paper web in a second position; rotating secured first and second rolls between the first and second positions about a horizontal axis simultaneously dispensing paper from said first and second rolls; operating as an oscillator circuit a first comparator adapted to run as an oscillator, the oscillator circuit adapted to have its period set by a hysteresis resistor, a variable trim resistor and a reference capacitor; balancing two components as a balanced bridge, the first component being a sensor having a capacitance on a first arm of said bridge and the second component being the reference capacitor on a second arm of the bridge; adjusting the voltage amplitudes on each arm of said bridge by a variable trim resistance; comparing voltages across each arm of said bridge utilizing a second comparator; latching and holding on the leading edge of the second comparator output voltage utilizing an edge-triggered d flip-flop. Preferably, the method further includes the step of activating a motor switch when detecting a change in the output state of the flip-flop.

A thirteenth additional aspect of the invention is a proximity detection circuit that includes: an asymmetric oscillator circuit having its on-period set by a resistor network including a plurality of fixed resistors and at least one variable resistor and having its off-period set by at least one fixed resistor and by at least one first single diode; a first static protection circuit including a first plurality of diodes, one said diode adapted to conduct away from ground, another said diode adapted to conduct toward the supply voltage; a reset path wherein a second single diode provides a discharge path for an antenna, wherein the antenna is discharged to the same voltage for every time period; the asymmetric oscillator being adapted to send an approximately uniform amount of charge during its on-period to said antenna; the antenna voltage being decreased when the capacitance of the antenna is increased by a detected object; a second static protection circuit comprising a second plurality of diodes, one said diode adapted to conduct away from ground, another said diode adapted to conduct toward the supply voltage; an antenna impedance buffer including operational amplifier operated as a unity gain follower with the output terminal of the operational amplifier being fed back to the inverting input terminal; a voltage peak detector including a third single diode, a current-limiting resistor, a peak storage capacitor and a bleed off resistor, the third single diode and said peak storage capacitor being adapted to capture the positive peak of the exponential waveforms, the current limiting resistor being adapted to limit current flow and to providing the antenna impedance buffer output with more phase margin to prevent oscillation, the bleed-off resistor adapted to providing a discharge pathway for said peak storage capacitor; a low-pass filter adapted to filter out about 50 or about 60 Hz alternating current interference frequencies, the low-pass filter comprising an in-line resistor and a capacitor with one side tied to ground; an amplifier with gain and voltage offset; an auto-compensation capacitor adapted to filter out changes in DC voltage levels of signals while allowing transient signals to pass through; a three-position switch adapted to provide three levels of detection sensitivity; and, an output comparator adapted to generate an output on signal when the signal voltage, applied to the non-inverting input terminal of said comparator, is greater than the reference voltage, which is applied to the inverting input terminal of the comparator. Preferably, the detected object includes a material with a dielectric constant at least equal to one-half the dielectric constant of water. Preferably, the transient signal is generated by a moving hand. Preferably, the circuit further includes a motor activation switch connected to receive an output of a flip-flop activated by the output signal of said output comparator.

A fourteenth additional aspect of the invention is a proximity detection circuit that includes: an oscillator circuit comprising a first comparator adapted to provide an asymmetric signal as input to an antenna sensor; an antenna sensor adapted to respond to a change in dielectric constant in the sensor's proximity; a first operational amplifier adapted to buffer the antenna sensor to a peak detector, wherein the antenna sensor has high impedance and the peak detector has low impedance; a low-pass filter adapted to filter out line noise frequencies in the 50 Hz and 60-Hz line ranges; a second operational amplifier adapted to provide voltage offset to an input signal to the second operational amplifier and to amplify a signal from the peak detector as output from the second operational amplifier; a second comparator adapted to produce an output pulse, wherein the output signal from the second operational amplifier is an input signal to the second comparator and is of sufficient duration, amplitude and speed of change to produce the output pulse.

A fifteenth additional aspect of the invention is a method for detecting small capacitance changes, the method including the steps of: detecting time of charge integration for an antenna detector with a larger dielectric constant; integrating a peak voltage proportional to the charge integration time, wherein the charge-integration time is inversely proportional to the resistance-capacitance time constant; producing an output signal from a peak voltage pulse integration, the output signal being adapted to activate a motor-controlling logic circuit. Preferably, the method further includes the step of: activating a motor switch when detecting a change in the output state of the flip-flop.

A sixteenth additional aspect of the invention is a method for detecting small capacitance changes, utilizing a proximity detection circuit. The method includes the steps of: producing an asymmetric oscillator circuit having its on-period set by a resistor network including a plurality of fixed resistors and at least one variable resistor and having its off-period set by at least one fixed resistor and by at least one first single diode; providing protection from static utilizing a first static protection circuit including a first plurality of diodes, one of the diodes adapted to conduct away from ground, and another diode adapted to conduct toward the supply voltage; resetting an antenna sensor voltage to a fixed amount utilizing a a reset path wherein a second single diode provides a discharge path for an antenna wherein the antenna is discharged to the same voltage for every time period; charging up an antenna with an antenna voltage wherein an approximately uniform amount of charge is sent by the asymmetric oscillator during its on-period to the antenna; having the voltage lower when the capacitance of the antenna is increased by a detected object with a relatively high dielectric constant; protecting against static in the proximity detector by utilizing a second static protection circuit including a second plurality of diodes, one said diode adapted to conduct away from ground, another said diode adapted to conduct toward the supply voltage; impedance buffering with an antenna impedance buffer wherein the buffer comprises a unity gain operational amplifier with the output terminal of the operational amplifier being fed back to the inverting input terminal; detecting a peak voltage utilizing a detector which includes a third single diode, a current-limiting resistor, a peak storage capacitor and a bleed off resistor; capturing the positive peak of the exponential waveforms utilizing the third single diode and the peak storage capacitor to capture the positive peak of the exponential waveforms; limiting current flow utilizing the current limiting resistor to limit current; preventing oscillation by providing the antenna impedance buffer output with more phase margin, by utilizing resistance of the current limiting resistor; providing a discharge pathway for the peak storage capacitor utilizing a bleed resistor; filtering out about 50 Hz and about 60 Hz alternating current interference frequencies utilizing a low-pass filter, the low-pass filter including an in-line resistor and a capacitor with one side tied to ground; providing voltage offset; amplifying signal with an operational amplifier; filtering out changes in DC voltage levels of signals while allowing transient signals, as generated by a waving hand, to pass through; providing three levels of detection sensitivity utilizing a three-position switch; generating an output on signal, utilizing an output comparator, when the signal voltage, applied to the inverting input terminal of the comparator, is less than the reference voltage, which the reference voltage is applied to the inverting input terminal of the comparator. Preferably, the method further includes the step of applying the output voltage at the output pin of the second comparator to a an edge-triggered control logic circuit. More preferably, the method includes the step of activating a motor switch when detecting a change in the output state of the second comparator.

A seventeenth additional aspect of the invention is an apparatus for dispensing paper from rolls. The apparatus includes: means for holding and positioning at least first and second rolls of paper with respect to each other; means for dispensing paper from the first roll; means for dispensing paper from the first and second rolls simultaneously when the first roll reduces to a predetermined diameter of paper; means for positioning the depleted first roll for replacement without the necessity of removing the second roll; means for dispensing from the second and replacement rolls simultaneously when the second roll reduces to a predetermined diameter of paper; and, a second proximity detector adapted to trigger the dispensing means when a user's hand is positioned within the field of the sensor. Preferably, the second proximity detector includes: an oscillator circuit comprising a first comparator adapted to provide an asymmetric signal as input to an antenna sensor; an antenna sensor adapted to respond to a change in dielectric constant In the sensor's proximity; a first operational amplifier adapted to buffer the antenna sensor to a peak detector, wherein the antenna sensor has high impedance and said peak detector has low impedance; a second operational amplifier adapted to provide voltage offset to an input signal to the second operational amplifier and to amplify a signal from the peak detector as output from the second operational amplifier; a second comparator adapted to produce an output pulse wherein the output signal from the second operational amplifier is an input signal to the second comparator and is of sufficient duration, amplitude and speed of change to produce the output pulse.

An eighteenth additional aspect of the invention is a dispenser for a paper web roll. The dispenser includes: a first support adapted to hold a first roll of a paper, a second support adapted to hold a second roll of a paper; a third support rigidly connected to first and second support wherein the third support is rotatable about an axis; a transfer bar, wherein paper from the second roll can be fed with paper from the first roll to dispense together; and, a second proximity detector adapted to trigger the dispensing of paper when a user's hand is positioned within the field of the sensor. The detector includes: an oscillator circuit comprising a first comparator adapted to provide an asymmetric signal as input to an antenna sensor; an antenna sensor adapted to respond to a change in dielectric constant in the sensor's proximity; a first operational amplifier adapted to buffer the antenna sensor to a peak detector, wherein the antenna sensor has high impedance and the peak detector has low impedance; a low-pass filter adapted to filter out line noise frequencies in the 50 Hz and 60 Hz line ranges; a second operational amplifier adapted to provide voltage offset to an input signal to the second operational amplifier and to amplify a signal from the peak detector as output from the second operational amplifier; a second comparator adapted to produce an output pulse wherein the output signal from the second operational amplifier is an input signal to the second comparator and is of sufficient duration, amplitude and speed of change to produce the output pulse. Preferably, the dispenser further includes means for providing a selectable dispensed paper length, the means including: motor means for dispensing paper from at least one roll; a first motor control sub-circuit;
a first switch adapted to control the first sub-circuit, the first sub-circuit being adapted to set the length of paper dispensed by said motor means according to the setting of the first switch. Preferably, the dispenser further includes means for providing a selectable time delay before dispenser can be reactivated to dispense another length of paper; that means includes: motor means for dispensing paper from at least one roll; a second motor control sub-circuit; a second switch adapted to control the second sub-circuit, the second sub-circuit being adapted to set a time delay for paper dispensed by said motor means according to the setting of the second switch. Preferably, the dispenser further includes means for providing a selectable sensitivity of said proximity sensor, the means including: a voltage divider in a leg of a reference voltage; a third switch adapted to select resistor combinations in the reference voltage leg, the selected resistors being adapted to set sensitivity of the proximity sensor.

A nineteenth additional aspect of the invention is a method for grounding a dispenser to a local ground. The method includes the steps of: providing an internal low impedance path from positions internal to and on the surface of the dispenser where static electrical charges tend to accumulate; connecting the low impedance path to a metal wall contact spring disposed to contact a ground surface when the dispenser is mounted; and, discharging said static electrical charges to a local ground through the grounding interface. Preferably the method further indudes the step of connecting a nib roller shaft of a paper towel dispenser to a grounding wire. More preferably, the method further includes the step of utilizing a spring contact to connect the nib roller shaft to the grounding wire, wherein the spring contact connects to the nib roller shaft.

A twentieth additional aspect of the invention is an apparatus for grounding a dispenser. The apparatus includes a dispenser that includes; a low-impedance grounding wire; a metal contact spring grounding clip; a spring contact disposed to connect to a location of static electricity accumulation in the dispenser; the low-impedance ground wire being disposed to connect to the spring contact and the metal contact spring grounding dip, the metal contact spring grounding clip being disposed to contact a wall; the metal contact spring grounding clip being disposed to connect electrically to a local ground. Preferably, the apparatus further includes the grounding wire being disposed to connect to a nib roller shaft of a paper towel dispenser. Preferably, the apparatus further includes the spring contact being disposed to connect to a nib roller compression spring, wherein the nib roller compression spring is disposed to contact a metal nib roller.

A twenty-first additional aspect of the invention includes: a first support adapted to hold a first roll of a paper; a second support adapted to hold a second roll of a paper; a third support rigidly connected to first and second support wherein the third support is rotatable about an axis; a transfer bar wherein paper from said second roll can be fed with paper from the first roll to dispense together; a detector adapted to trigger the dispensing of paper when a user's hand is positioned within the field of the sensor; and, a grounding apparatus. The grouding apparatus includes: a low-impedance grounding wire; a metal wall-contact spring grounding clip; and, a spring contact disposed to connect to a location in a dispenser of static electricity accumulation. The low-impedance ground wire is disposed to connect to the spring contact and the metal wall contact spring grounding clip. The metal wall contact spring grounding clip is disposed to contact by spring pressure to a wall. The metal wall contact spring grounding clip is disposed to connect electrically to a local ground.

Although the present invention and its advantages have been described in detail, it should be understood that various changes, substitutions and alterations can be made herein without departing from the scope of the invention as defined by the appended claims. Moreover, the scope of the present Invention is not intended to be limited to the particular embodiments of the process, machine, manufacture, composition of matter, means, methods and steps described in the specification. As one of ordinary skill in the art will readily appreciate from the disclosure of the present invention, processes, machines, manufacture, compositions of matter, means, methods, or steps, presently existing or later to be developed that perform substantially the same function or achieve substantially the same result as the corresponding embodiments described herein may be utilized according to the present invention. Accordingly, the appended claims are intended to include within their scope such processes, machines, manufacture, compositions of matter, means, methods, or steps.

Each feature disclosed in this specification (which term includes the claims) and/or shown in the drawings may be incorporated in the invention independently of other disclosed and/or illustrated features.

The text of the abstract filed herewith is repeated here as part of the specification.

Apparatus for dispensing paper from rolls which feeds continuously, roll to roll, and does not require extra procedure to bring stub roll into position. The apparatus has means for holding and positioning at least first and second rolls of paper with respect to each other; means for dispensing paper from the first roll; means for dispensing paper from the first and second rolls simultaneously whent he first roll reduces to a predetermined diameter of paper, means for positioning the depleted first roll for replacement without the necessity of removing the second roll; and, means for dispensing from the second and replacement rolls simultaneously when the second roll reduces to a predetermined diameter of paper. The apparatus also has a capacity-change-based proximity sensor comprising a circuit according to a balanced bridge principle where detection is based on detecting a phase difference, which depends upon the amount of detected capacitance difference or change. The proximity detector senses when a hand is placed near the dispenser, and thereupon dispenses a set amount of towel. It does not keep dispensing the towel. The hand must be withdrawn and placed in proximity to the sensor again. The proximity sensor incorporates "static" and noise-immunity circuitry. The dispenser incorporates means for dissipating static charges to a local ground.

**Claims**

1. A dispenser for flexible sheet material comprising:

   a support adapted to hold a roll of flexible sheet material;
   a motor driven feed mechanism adapted to receive and dispense flexible sheet material from the roll;
   a surface contactor adapted to directly contact a mounting surface external to the dispenser when the dispenser is affixed to the mounting surface; and at least one low impedance wire having a first end electrically coupled to the surface contactor and a second end coupled to an internal element to the dispenser.

2. The dispenser for flexible sheet material of claim 1, wherein said motor driven feed mechanism comprises a nib roller in contact with the flexible sheet material and the second end of said low impedance wire is connected to said nib roller.

3. The dispenser for flexible sheet material of claim 2, wherein the second end of said low impedance wire is connected to said nib roller by a spring contact.

4. The dispenser for flexible sheet material of claim 3, wherein the nib roller comprise a shaft and the spring contact couples the second end of the at least one low impedance wire to the shaft.

5. The dispenser for flexible sheet material of any of the preceding claims, wherein the mounting surface comprises a wall.

6. The dispenser for flexible sheet material of claim 5, wherein the wall is formed from a high impedance material.

7. The dispenser for flexible sheet material of claim 5 wherein the dispenser comprises a chassis, said chassis being affixed to the mounting surface.

8. The dispenser for flexible sheet material of claim 7 wherein the chassis is formed from a plastic material

9. The dispenser for flexible sheet material of claim 1 further comprising a battery electrically coupled to the motor driven feed mechanism.

10. The dispenser for flexible sheet material of claim 1 wherein said surface contactor comprises a spring.

11. The dispenser for flexible sheet material of any of the preceding claims further comprising a proximity detection circuit for activating said feed mechanism.

FIG. 1

FIG. 2

FIG. 3

FIG. 4A

FIG. 4B

FIG. 4C

FIG. 5

*FIG. 6A*

FIG. 6B

FIG. 7A

FIG. 7B

FIG. 7C

126

128

FIG. 7D

FIG. 8A

EP 1 716 800 A2

FIG. 8B
PRIOR ART

FIG. 9

CLOCK, U1A, pin1

ANT, U1B, pin5

CREF, U1B, pin6

A

B

C

FIG. 10

| FIG. 10B | FIG. 10C | FIG. 10D |
|----------|----------|----------|
| FIG. 10A | | FIG. 10E |

FIG. 10A

*FIG. 10B*

LESS EXTERNAL LOAD (LESS CAPACITANCE) CAUSES
THE ANTENNA TO CHARGE TO A HIGHER VOLTAGE.

MORE EXTERNAL LOAD (MORE CAPACITANCE) CAUSES
THE ANTENNA TO CHARGE TO A LOWER VOLTAGE.

FIG. 10C

LOW-PASS FILTER (50/60Hz REJECT)

R1 AND C1 HAVE A CORNER FREQUENCY OF 200Hz

ADJUST VR1 (CHARGE-TIME ADJUST) FOR 3.0V BETWEEN TP1 & TP2. ALL EXTERNAL LOADING MUST BE IN PLACE BEFORE THIS ADJUSTMENT IS PERFORMED.

TP1 278 TP

TP2 280 TP

234 XVDD

274 XR3 301K 2 1 276

277 XR5 1 2 3.3M

268 OP-AMP XU1B

OPA2347UA SO-8

279 4 6 X − 7

266 5 + X 8

AMPLIFIER WITH GAIN AND OFFSET

XR11 301K 1 2 276

270 XR1 1 2 499K

272 XC1 1 2 .1uF

37

FIG. 10D

SENSITIVITY
SELECT
LO−MED−HI

*298*

*296* XSW1
SW SLIDE−SP3T

4 3 2 X 1

2
XR14 *304*
10K

1

THE CLOSER THAT THE REFERENCE (REF)
IS TO THE SIGNAL LEVEL. THE MORE SENSITIVE
THE CIRCUIT IS TO CHANGES AT THE ANTENNA

2
XR16 *302*
20K

1

2
XR19 *300*
453K

1

*FIG. 10E*

FIG. 11A

EP 1 716 800 A2

*FIG. 11B*

*FIG. 11C*

*FIG. 16*

EP 1 716 800 A2

FIG. 12A

43

FIG. 12B

## FIG. 12C

EP 1 716 800 A2

FIG. 13

## FIG. 14A

2028

2026

## FIG. 14B

2020

2002

FIG. 15

EP 1 716 800 A2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 3743865 A